# EUROPEAN PATENT APPLICATION

(11) **EP 4 615 187 A1**
(43) Date of publication of application: **10.09.2025**
(21) Application number: 24211882.6
(22) Date of filing: 08.11.2024
(51) Int. Cl.: H10B 12/00

(54) **SEMICONDUCTOR DEVICE**

(30) Priority: 05.03.2024 KR 20240031511
(71) Applicant: Samsung Electronics Co., Ltd., Suwon-si, Gyeonggi-do 16677 (KR)
(72) Inventor: CHOI, Hyungeun, 16677 Suwon-si (KR); KIM, Suklae, 16677 Suwon-si (KR); KIM, Cheonbae, 16677 Suwon-si (KR); PARK, Taejin, 16677 Suwon-si (KR); YIM, Sung Soo, 16677 Suwon-si (KR); JANG, Yoona, 16677 Suwon-si (KR); JEONG, Hyunyong, 16677 Suwon-si (KR)
(74) Representative: Marks & Clerk LLP

(57) **Abstract**

A semiconductor device may include a substrate including a cell array region, data storage patterns on the cell array region and spaced apart from each other in a first direction and a second direction that are parallel to a top surface of the substrate, word lines on the data storage patterns, extending in the second direction, and spaced apart from each other in the first direction, bit lines on the word lines to cross the word lines, extending in the first direction, and spaced apart from each other in the second direction, an insulating pattern on the bit lines, bit line contacts in the insulating pattern and electrically connected to the bit lines, respectively, and word line contacts in the insulating pattern between the bit lines and electrically connected to the word lines, respectively. The bit line contacts and the word line contacts may be on the cell array region.

## Description

### BACKGROUND OF THE INVENTION

The present disclosure relates to a semiconductor device, and in particular, to a semiconductor device including vertical channel transistors.

As a semiconductor device is scaled down, it may be beneficial to develop a fabrication technology capable of increasing an integration density of a semiconductor device and improving an operation speed and a production yield. Thus, semiconductor devices with vertical channel transistors have been suggested to increase an integration density of a semiconductor device and improve resistance and current driving characteristics of the transistors.

### SUMMARY OF THE INVENTION

An embodiment of the inventive concept provides a semiconductor device with a reduced size and a method of fabricating the same.

An embodiment of the inventive concept provides a semiconductor device with improved electrical and reliability characteristics.

According to an embodiment of the inventive concept, a semiconductor device may include a substrate including a cell array region, data storage patterns on the cell array region and spaced apart from each other in a first direction and a second direction that are parallel to a top surface of the substrate and cross each other, word lines on the data storage patterns, extending in the second direction, and spaced apart from each other in the first direction, bit lines on the word lines to cross the word lines, extending in the first direction, and spaced apart from each other in the second direction, an insulating pattern on the bit lines, bit line contacts in the insulating pattern and electrically connected to the bit lines, respectively, and word line contacts in the insulating pattern between the bit lines and electrically connected to the word lines, respectively. The bit line contacts and the word line contacts may be on the cell array region.

According to an embodiment of the inventive concept, a semiconductor device may include a substrate including a cell array region, a cell structure on the substrate, and a peripheral circuit structure on the cell structure. The cell structure may include a plurality of data storage patterns spaced apart from each other in a horizontal direction, word lines on the data storage patterns, bit lines on the word lines to cross the word lines, bit line contacts electrically connected to the bit lines, respectively, word line contacts electrically connected to the word lines, respectively, and cell bonding pads first ones of which are electrically connected to the bit line contacts and second ones of which are electrically connected to the word line contacts. The bit line contacts and the word line contacts may be on the cell array region, and the peripheral circuit structure may be electrically connected to the cell structure through the cell bonding pads.

According to an embodiment of the inventive concept, a semiconductor device may include a substrate including a cell array region, a cell structure on the substrate, and a peripheral circuit structure on the cell structure. The cell structure including a plurality of data storage patterns spaced apart from each other in a horizontal direction, semiconductor patterns on the data storage patterns and extending in a vertical direction perpendicular to a top surface of the substrate, word lines on the data storage patterns and adjacent to the semiconductor patterns, gate insulating patterns that are respectively between the word lines and the semiconductor patterns, bit lines that are on the word lines to cross the word lines and are electrically connected to the semiconductor patterns, an insulating pattern on the bit lines, a shielding structure between the bit lines and extending to a region on the insulating pattern, bit line contacts in the shielding structure and the insulating pattern and electrically connected to the bit lines, respectively, word line contacts in the shielding structure and the insulating pattern and electrically connected to the word lines, respectively, and cell bonding pads, first ones of which are electrically connected to the bit line contacts and second ones of which are electrically connected to the word line contacts. The bit line contacts and the word line contacts may be on the cell array region, and the peripheral circuit structure may be electrically connected to the cell structure through the cell bonding pads.

At least some of the above and other features of the invention are set out in the claims.

### BRIEF DESCRIPTION OF THE DRAWINGS

FIG. 1 is a block diagram illustrating a semiconductor device according to an embodiment of the inventive concept.
FIGS. 2 and 3 are perspective views schematically illustrating a semiconductor device according to an embodiment of the inventive concept.
FIG. 4 is a plan view illustrating a semiconductor device according to an embodiment of the inventive concept.
FIGS. 5A and 5B are sectional views taken along lines A-A' and B-B', respectively, of FIG. 4.
FIGS. 6A, 6B, 7A, 7B, 8A, and 8B are sectional views illustrating a semiconductor device according to an embodiment of the inventive concept.
FIGS. 9A, 10A, 11A, 12A, and 13A are sectional views illustrating a method of fabricating a semiconductor device, according to an embodiment of the inventive concept, and corresponding to the line A-A' of FIG. 4.
FIGS. 9B, 10B, 11B, 12B, and 13B are sectional views illustrating a method of fabricating a semiconductor device, according to an embodiment of the inventive concept, and corresponding to the line B-B' of FIG. 4.
FIGS. 14 to 19 are sectional views illustrating a method of fabricating a semiconductor device, according to an embodiment of the inventive concept, and corresponding to the line A-A' of FIG. 4.
FIGS. 20A and 20B are sectional views illustrating a semiconductor device according to an embodiment of the inventive concept and corresponding to the line A-A' of FIG. 4.
FIGS. 21A, 21B, 22A, 22B, 23A, and 23B are sectional views illustrating a semiconductor device according to an embodiment of the inventive concept.
FIGS. 24A, 24B, 25A, 25B, 26A, 26B, 27A, and 27B are diagrams illustrating a method of fabricating a semiconductor device, according to an embodiment of the inventive concept.

### DETAILED DESCRIPTION

Example embodiments of the inventive concepts will now be described more fully with reference to the accompanying drawings, in which example embodiments are shown.

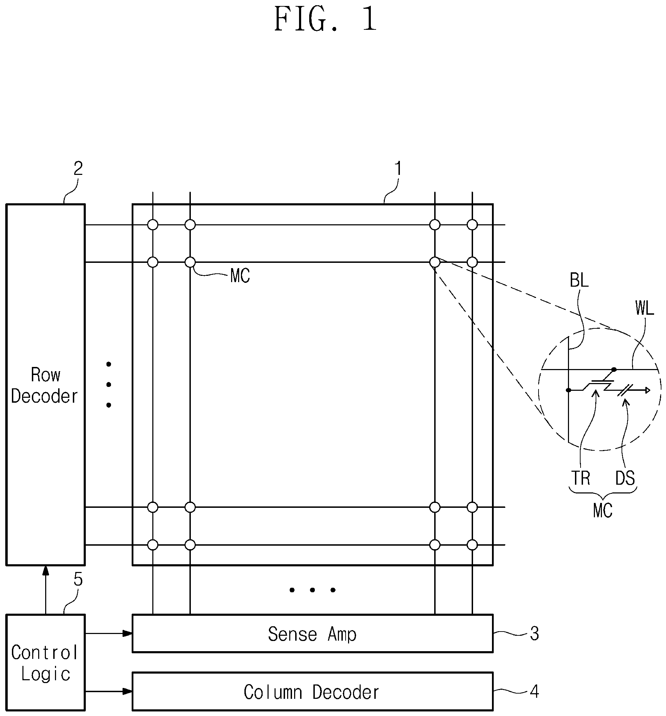

FIG. 1 is a block diagram illustrating a semiconductor device according to an embodiment of the inventive concept.

Referring to FIG. 1, a semiconductor device may include a memory cell array 1, a row decoder 2, a sense amplifier 3, a column decoder 4, and a control logic 5.

The memory cell array 1 may include a plurality of memory cells MC, which are two- or three-dimensionally arranged. Each of the memory cells MC may be provided between and connected to a word line WL and a bit line BL, which are provided to cross each other.

Each of the memory cells MC may include a selection element TR and a data storage element DS. The selection element TR and the data storage element DS may be electrically connected to each other. The selection element TR may be connected to both the word line WL and the bit line BL. In other words, the selection element TR may be provided at an intersection of the word and bit lines WL and BL.

The selection element TR may include a field effect transistor. The data storage element DS may include a capacitor, a magnetic tunnel junction pattern, or a variable resistor. As an example, the selection element TR may be a transistor whose gate, source, and drain terminals are connected to the word line WL, the bit line BL, and the data storage element DS, respectively.

The row decoder 2 may be configured to decode address information, which is input from the outside (e.g., from outside of the semiconductor device), and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may establish a data transmission path between the sense amplifier 3 and an external device (e.g., a memory controller). The column decoder 4 may be configured to decode address information, which is input from the outside (e.g., from outside of the semiconductor device), and to select one of the bit lines BL, based on the decoded address information.

The control logic 5 may generate control signals, which are used to control an operation of writing or reading data to or from the memory cell array 1.

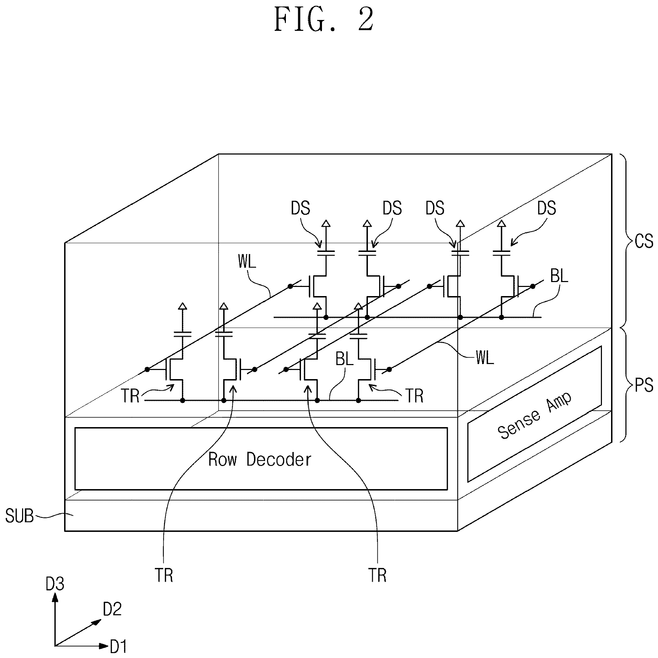

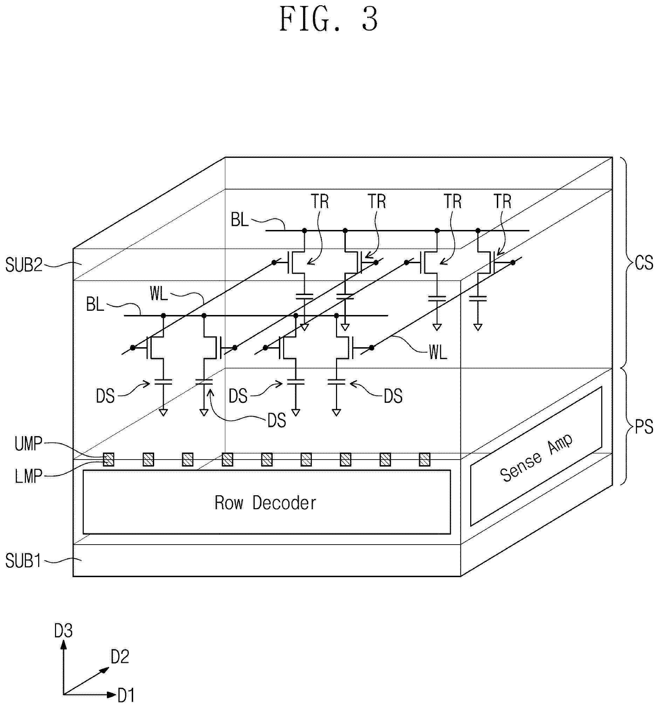

FIGS. 2 and 3 are perspective views schematically illustrating a semiconductor device according to an embodiment of the inventive concept.

Referring to FIGS. 2 and 3, the semiconductor device may include a peripheral circuit structure PS, and a cell structure CS, which are connected to each other.

The peripheral circuit structure PS may include core and peripheral circuits, which are formed on a substrate SUB. The core and peripheral circuits may include the row and column decoders 2 and 4, the sense amplifier 3, and the control logics 5 described with reference to FIG. 1.

The cell structure CS may include the memory cell array 1 of FIG. 1, in which the memory cells MC of FIG. 1 are two- or three-dimensionally arranged. Each of the memory cells MC of FIG. 1 may include the selection element TR and the data storage element DS, as described above.

In an embodiment, the selection element TR of each of the memory cells MC of FIG. 1 may include a vertical channel transistor (VCT). The vertical channel transistor may have a channel region whose lengthwise direction is substantially normal (i.e., perpendicular) to a top surface of the substrate SUB. The data storage element DS of each of the memory cells MC of FIG. 1 may include a capacitor.

In the embodiment of FIG. 2, the peripheral circuit structure PS may be provided on the substrate SUB, and the cell structure CS may be provided on the peripheral circuit structure PS.

In the embodiment of FIG. 3, the peripheral circuit structure PS may be provided on a first substrate SUB1, and the cell structure CS may be provided on a second substrate SUB2. The first and second substrates SUB 1 and SUB2 may be provided to face each other.

First metal pads LMP may be provided in the uppermost portion of the peripheral circuit structure PS. The first metal pads LMP may be electrically connected to the core and peripheral circuits (e.g., 2, 3, 4, and 5 of FIG. 1).

Second metal pads UMP may be provided in the lowermost portion of the cell structure CS. The second metal pads UMP may be electrically connected to the memory cell array 1 of FIG. 1. The second metal pads UMP may be directly bonded to (i.e., in direct contact with) the first metal pads LMP of the peripheral circuit structure PS.

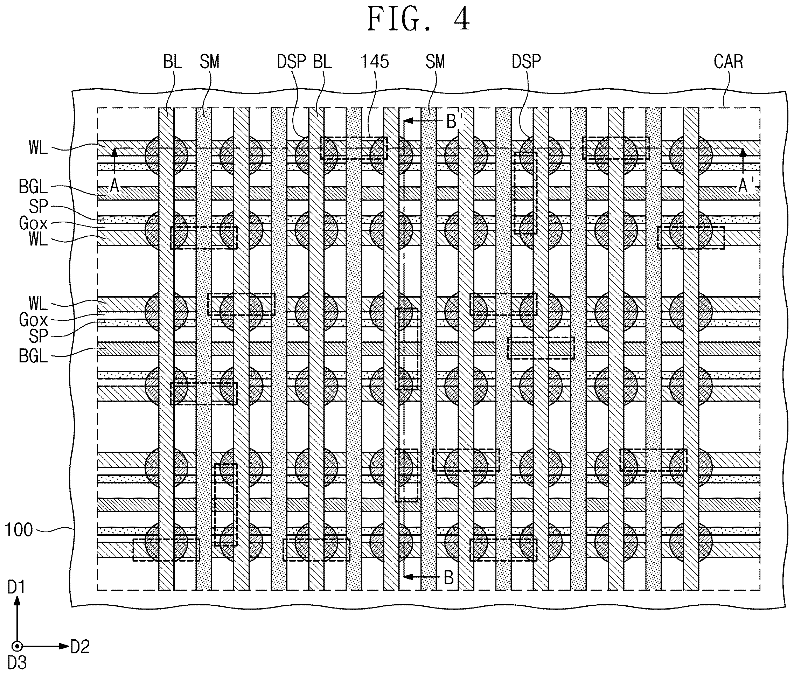

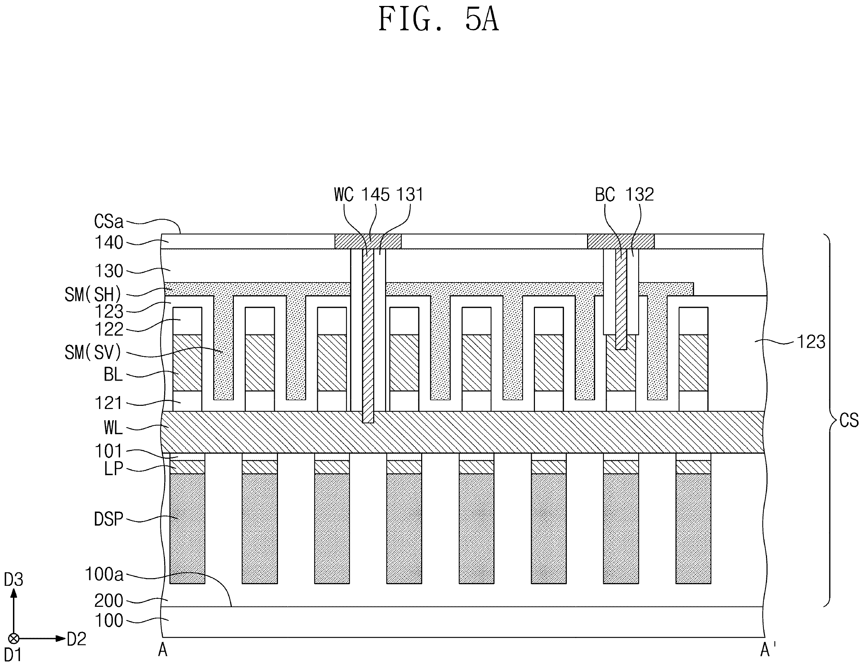

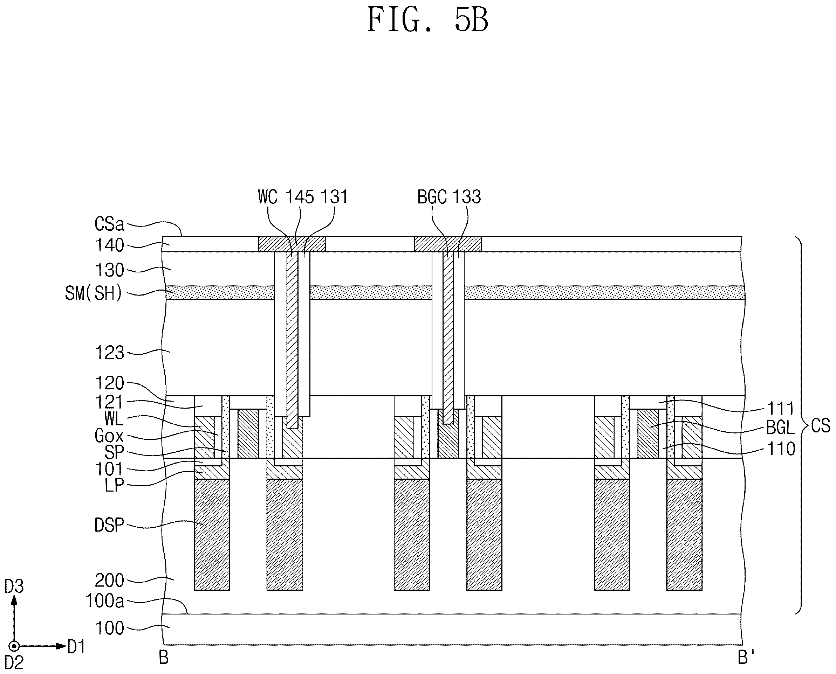

FIG. 4 is a plan view illustrating a semiconductor device according to an embodiment of the inventive concept. FIGS. 5A and 5B are sectional views taken along lines A-A' and B-B', respectively, of FIG. 4.

Referring to FIGS. 4, 5A, and 5B, the cell structure CS may be provided on a substrate 100 including a cell array region CAR. The cell structure CS may include a lower insulating layer 200, which is disposed on the cell array region CAR of the substrate 100. The lower insulating layer 200 may extend in a first direction D1 and a second direction D2. In the present specification, the first and second directions D1 and D2 may be parallel to a top surface 100a of the substrate 100 and may not be parallel to each other. The first and second directions D1 and D2 may be referred to as horizontal directions D1 and D2. A third direction D3 may be a vertical direction D3 that is perpendicular to the top surface 100a of the substrate 100. The third direction D3 may be referred to as the vertical direction D3. For example, the first, second, and third directions D1, D2, and D3 may be orthogonal to each other.

Unlike that illustrated in the drawings, the lower insulating layer 200 may be composed of a plurality of insulating layers. In an embodiment, the lower insulating layer 200 may be formed of or include at least one of various insulating materials (e.g., silicon oxide, silicon nitride, silicon oxynitride, and/or low-k dielectric materials).

Data storage patterns DSP may be disposed in the lower insulating layer 200 and on the cell array region CAR. The data storage patterns DSP may be spaced apart from each other in the first and second directions D1 and D2. The lower insulating layer 200 may be on (e.g., may cover) the data storage patterns DSP. The lower insulating layer 200 may fill a space between the data storage patterns DSP and may be in contact with the top surface 100a of the substrate 100.

According to an embodiment of the inventive concept, the data storage pattern DSP may be a capacitor, although not shown, and may include bottom and top electrodes and a capacitor dielectric layer interposed therebetween. In this case, the bottom electrode may be in contact with a landing pad LP and may have various shapes (e.g., circular, elliptical, rectangular, square, lozenge, and hexagonal shapes), when viewed in a plan view.

Alternatively, the data storage patterns DSP may be a variable resistance pattern whose resistance can be switched to one of at least two states by an electric pulse applied thereto. For example, the data storage pattern DSP may be formed of or include at least one of various phase-change materials whose crystal state can be changed depending on an amount of a current applied thereto, perovskite compounds, transition metal oxides, magnetic materials, ferromagnetic materials, or antiferromagnetic materials.

The landing pads LP and first capping patterns 101 may be disposed on the data storage patterns DSP, respectively. The landing pad LP may be in contact with the data storage pattern DSP and a semiconductor pattern SP, which will be described below. The first capping pattern 101 may be disposed on the landing pad LP and may be disposed on a bottom surface of a word line WL, which will be described below.

In an embodiment, the landing pads LP may be formed of or include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or combinations thereof, but the inventive concept is not limited to this example. The first capping patterns 101 may be formed of or include at least one of silicon oxide, silicon nitride, or silicon oxynitride.

The word line WL may be disposed on the lower insulating layer 200. In an embodiment, a plurality of word lines WL may be provided. In addition, the word lines WL may be disposed on the data storage patterns DSP. The first capping pattern 101 may be interposed between the word line WL and the data storage pattern DSP. The word lines WL may extend in the second direction D2 and may be spaced apart from each other in the first direction D1. As shown in FIGS. 4, 5A, and 5B, the data storage patterns DSP may be vertically overlapped with (i.e., by) corresponding ones of the word lines WL.

A back-gate line BGL may be disposed on the lower insulating layer 200. In an embodiment, a plurality of back-gate lines BGL may be provided to extend in the second direction D2 and may be spaced apart from each other in the first direction D1. The back-gate lines BGL may be disposed between the word lines WL. In detail, each of the back-gate lines BGL may be disposed between a respective pair of the word lines WL, which are spaced apart from each other in the first direction D1.

In an embodiment, the word lines WL and the back-gate lines BGL may be formed of or include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or combinations thereof, but the inventive concept is not limited to this example.

A semiconductor pattern SP may be disposed on the lower insulating layer 200. In an embodiment, a plurality of semiconductor patterns SP may be provided to extend in the second direction D2 and may be spaced apart from each other in the first direction D1. Each of the semiconductor patterns SP may be disposed at a side of a corresponding one of the word line WL. The semiconductor pattern SP may be disposed between the word line WL and the back-gate line BGL. As an example, a pair of the word lines WL may be defined among the word lines WL spaced apart from each other in the first direction D1. The semiconductor patterns SP may be disposed in a direction where the pair of the word lines WL face each other. The word line WL and the back-gate line BGL may be respectively disposed at opposite sides of the semiconductor pattern SP. The semiconductor patterns SP may be disposed at opposite sides of the back-gate line BGL. The back-gate line BGL may be disposed between an adjacent pair of the semiconductor patterns SP, which are placed to face each other.

The semiconductor pattern SP may have a vertical channel structure, in which a channel length is defined in the vertical direction D3. A bottom surface of each of the semiconductor patterns SP may be in contact with a corresponding one of the landing pads LP. That is, each of the semiconductor patterns SP may be electrically connected to the landing pad LP.

As an example, the semiconductor pattern SP may be formed of doped silicon. As another example, the semiconductor pattern SP may be formed of or include at least one of oxide semiconductor materials. In an embodiment, the oxide semiconductor material may include at least one of InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, and InₓGa_{y}O, but the inventive concept is not limited to this example. In an embodiment, the semiconductor pattern SP may include Indium Gallium Zinc Oxide (IGZO). The semiconductor pattern SP may have a single- or multi-layered structure that is made of the oxide semiconductor material.

A gate insulating pattern Gox may be provided on the lower insulating layer 200 and may be interposed between the word line WL and the semiconductor pattern SP. In an embodiment, a plurality of gate insulating patterns Gox may be provided to extend in the second direction D2 and may be spaced apart from each other in the first direction D1. The word line WL may be spaced apart from a corresponding one of the semiconductor patterns SP with the gate insulating pattern Gox interposed therebetween.

The gate insulating pattern Gox may be formed of or include at least one of silicon oxide, silicon oxynitride, or high-k dielectric materials, or combinations thereof. The high-k dielectric material may be formed of at least one of metal oxide materials or metal oxynitride materials. In an embodiment, the high-k dielectric material may include HfO₂, HfSiO, HfSiON, HfTaO, HfTiO, HfZrO, ZrO₂, Al₂O₃, or combinations thereof.

A second capping pattern 121 may be disposed on the word line WL and the gate insulating pattern Gox. In an embodiment, a plurality of second capping patterns 121 may be provided on the word lines WL and the gate insulating patterns Gox, respectively. The semiconductor pattern SP may extend to the same level as a top surface of the second capping pattern 121 in the vertical direction D3. For example, the top surface of the second capping pattern 121 may be coplanar with the top surface of the semiconductor pattern SP. In the present specification, the term 'height' will be used to refer to a length measured from the top surface 100a of the substrate 100 in the vertical direction D3. The top surface of the semiconductor pattern SP may be located at a height that is higher than the top surfaces of the word line WL and the gate insulating pattern Gox.

In an embodiment, the second capping pattern 121 may be formed of or include at least one of silicon oxide, silicon nitride, or silicon oxynitride.

Back-gate insulating patterns 110 (FIG. 5B) may be disposed on the lower insulating layer 200 and on opposite side surfaces of each of the back-gate lines BGL, respectively. The back-gate insulating patterns 110 may be respectively interposed between the back-gate line BGL and the semiconductor patterns SP adjacent thereto. The back-gate line BGL may be spaced apart from the semiconductor patterns SP with the back-gate insulating patterns 110 interposed therebetween.

The back-gate insulating pattern 110 may be formed of or include at least one of silicon oxide, silicon oxynitride, high-k dielectric materials having a higher dielectric constant than the silicon oxide, or combinations thereof. The high-k dielectric material may be formed of at least one of metal oxide materials or metal oxynitride materials. In an embodiment, the high-k dielectric material may include HfO₂, HfSiO, HfSiON, HfTaO, HfTiO, HfZrO, ZrO₂, Al₂O₃, or combinations thereof.

A back-gate capping pattern 111 may be disposed on a pair of the back-gate insulating patterns 110 and the back-gate line BGL therebetween. The back-gate capping pattern 111 may be disposed between an adjacent pair of the semiconductor patterns SP which are placed to face each other. A top surface of the back-gate capping pattern 111 may be coplanar with the top surface of the semiconductor pattern SP. The back-gate capping pattern 111 may be formed of or include at least one of silicon oxide, silicon nitride, or silicon oxynitride.

A first insulating pattern 120 may be disposed on the lower insulating layer 200. In an embodiment, a plurality of first insulating patterns 120 may be provided. The first insulating patterns 120 may be disposed between the word lines WL facing each other. In other words, the semiconductor pattern SP and the first insulating pattern 120 may be respectively disposed at opposite sides of each of the word lines WL. The first insulating patterns 120 may extend in the second direction D2 and may be spaced apart from each other in the first direction D1. The top surface of the first insulating pattern 120 may be coplanar with the top surfaces of the second capping pattern 121, the semiconductor pattern SP, and the back-gate capping pattern 111.

In an embodiment, the first insulating pattern 120 may be formed of or include at least one of silicon oxide, silicon nitride, silicon oxynitride, or low-k dielectric materials. As an example, the first insulating pattern 120 may have a single- or multi-layered structure.

The bit line BL may be disposed on the first insulating patterns 120, the word lines WL, the back-gate lines BGL, the semiconductor patterns SP, the gate insulating patterns Gox, the back-gate insulating patterns 110, the second capping patterns 121, and the back-gate capping patterns 111. The bit line BL may extend in a direction crossing (i.e., intersecting) the word lines WL (i.e., in the first direction D1). In an embodiment, a plurality of bit lines BL may be provided and may be spaced apart from each other in the second direction D2.

The bit line BL may be in contact with top surfaces of corresponding ones of the semiconductor patterns SP. That is, the semiconductor patterns SP may be electrically connected to the bit line BL. As shown in FIGS. 4 and 5A, the bit lines BL may vertically overlap corresponding ones of the data storage patterns DSP.

For example, the bit line BL may be formed of or include at least one of doped polysilicon, metallic materials (e.g., Al, Cu, Ti, Ta, Ru, W, Mo, Pt, Ni, Co), conductive metal nitride materials (e.g., TiN, TaN, WN, NbN, TiAlN, TiSiN, TaSiN, RuTiN), conductive metal silicide materials, or conductive metal oxide materials (e.g., PtO, RuO₂, IrO₂, SrRuO₃ (SRO), (Ba,Sr)RuO₃ (BSRO), CaRuO₃ (CRO), LSCo), but the inventive concept is not limited to this example. The bit line BL may be provided to have a single- or multi-layered structure formed of the afore-described materials. In an embodiment, the bit line BL may be formed of or include at least one of two-dimensional semiconductor materials (e.g., graphene, carbon nanotube, or combinations thereof).

A capping layer 122 may be disposed on the bit line BL. In an embodiment, the capping layer 122 may be formed of or include at least one of silicon oxide, silicon nitride, silicon oxynitride, or low-k dielectric materials.

A second insulating pattern 123 may be on (e.g., may be disposed to cover) the bit lines BL. The second insulating pattern 123 may be conformally formed on (e.g., may conformally cover) the second capping pattern 121, the bit line BL, and the capping layer 122 and may extend to a region on the word line WL. The second insulating pattern 123 may be formed of or include at least one of silicon oxide, silicon nitride, silicon oxynitride, or low-k dielectric materials.

A shielding structure SM may be disposed between the bit lines BL. The shielding structure SM may include vertical portions SV and a horizontal portion SH. In detail, the vertical portions SV of the shielding structure SM may be respectively disposed between the bit lines BL. In an embodiment, a plurality of vertical portions SV may extend in the first direction D1 and may be spaced apart from each other in the second direction D2. The vertical portion SV may be spaced apart from the bit line BL, with the second insulating pattern 123 interposed therebetween. A bottom surface of the vertical portion SV may not be in contact with the word line WL. The vertical portion SV may extend to a level that is higher than a top surface of the capping layer 122 in the vertical direction D3.

The horizontal portion SH of the shielding structure SM may be disposed on the second insulating pattern 123. The horizontal portion SH may connect the vertical portions SV to each other. That is, the second insulating pattern 123 may be interposed between the shielding structure SM and the stack of the second capping pattern 121, the bit line BL, and the capping layer 122 and may extend to a region on the word line WL. The shielding structure SM may be formed of or include at least one of various conductive materials (e.g., metallic materials).

A first interlayer insulating layer 130 may be disposed on the second insulating pattern 123 and the shielding structure SM. The first interlayer insulating layer 130 may be on (e.g., may cover) the shielding structure SM. A second interlayer insulating layer 140 may be disposed on the first interlayer insulating layer 130. The first interlayer insulating layer 130 and the second interlayer insulating layer 140 may be formed of or include at least one of silicon oxide, silicon nitride, silicon oxynitride, or low-k dielectric materials.

A word line contact WC may be in (e.g., may be disposed to penetrate) the first interlayer insulating layer 130, the shielding structure SM, the second insulating pattern 123, and the second capping pattern 121 and may be electrically connected to the word line WL. Unlike the illustrated structure, a width of the word line contact WC in the horizontal direction D1 or D2 may increase, as a distance from the substrate 100 in the vertical direction D3 increases. In an embodiment, the word line contact WC may be in (e.g., may be provided to penetrate) both the horizontal and vertical portions SH and SV of the shielding structure SM. A bottom surface of the word line contact WC may be lower than the top surface of the word line WL. In an embodiment, a plurality of word line contacts WC may be provided, and each of the word line contacts WC may be electrically connected to a corresponding one of the word lines WL. The word line contact WC may be disposed on the cell array region CAR of the substrate 100. As shown in FIGS. 4, 5A, and 5B, the word line contact WC may vertically overlap the data storage pattern DSP. Alternatively, even when the word line contact WC does not vertically overlap the data storage pattern DSP, it may vertically overlap a region between the data storage patterns DSP. The word line contact WC may be disposed in a region that vertically overlaps a region in which the data storage patterns DSP are arranged in an array shape.

A first spacer 131 may be conformally formed on (e.g., may be disposed to conformally cover) a side surface of the word line contact WC. A bottom surface of the first spacer 131 may be in contact with the top surfaces of the word line WL and the gate insulating pattern Gox. In other words, the lowermost end of the word line contact WC may not be enclosed by the first spacer 131. The lowermost end of the word line contact WC may be in (e.g., may penetrate) at least a portion of the word line WL and may be in contact with the word line WL. Owing to the first spacer 131, the word line contact WC may be electrically isolated (e.g., electrically disconnected) from the shielding structure SM.

A bit line contact BC may be in (e.g., may be disposed to penetrate) the first interlayer insulating layer 130, the capping layer 122, the horizontal portion SH of the shielding structure SM and in (e.g., may penetrate) a portion of the second insulating pattern 123 in the vertical depth and may be connected (e.g., electrically connected) to the bit line BL. Unlike the illustrated structure, a width of the bit line contact BC in the horizontal direction D1 or D2 may increase as a distance from the substrate 100 in the vertical direction D3 increases. A bottom surface of the bit line contact BC may be lower than a top surface of the bit line BL. In an embodiment, a plurality of bit line contacts BC may be provided, and each of the bit line contacts BC may be electrically connected to a corresponding one of the bit lines BL. The bit line contact BC may be disposed on the cell array region CAR of the substrate 100. As shown in FIGS. 4 and 5A, the bit line contact BC may vertically overlap the data storage pattern DSP. Alternatively, even when the bit line contact BC does not vertically overlap the data storage pattern DSP, it may vertically overlap a region between the data storage patterns DSP. The bit line contact BC may be disposed in a region that vertically overlaps a region in which the data storage patterns DSP are arranged in an array shape.

A second spacer 132 may be disposed on (e.g., to enclose) a side surface of the bit line contact BC. A bottom surface of the second spacer 132 may be in contact with the top surface of the bit line BL. In other words, the lowermost end of the bit line contact BC may not be enclosed by the second spacer 132. The lowermost end of the bit line contact BC may be in (e.g., may penetrate) at least a portion of the bit line BL and may be in contact with the bit line BL. The bit line contact BC may be electrically isolated (e.g., electrically disconnected) from the shielding structure SM by the second spacer 132.

A back-gate contact BGC may be in (e.g., may be disposed to penetrate) the first interlayer insulating layer 130, the shielding structure SM, the second insulating pattern 123, and the back-gate capping pattern 111 and may be electrically connected to the back-gate line BGL. In an embodiment, the back-gate contact BGC may be in (e.g., may penetrate) both of the horizontal and vertical portions SH and SV of the shielding structure SM, unlike the illustrated structure. A width of the back-gate contact BGC in the horizontal direction D1 or D2 may increase as a distance from the substrate 100 in the vertical direction D3 increases, unlike the illustrated structure. A bottom surface of the back-gate contact BGC may be lower than the top surface of the back-gate line BGL. In an embodiment, a plurality of back-gate contacts BGC may be provided, and each of the back-gate contacts BGC may be connected to a corresponding one of the back-gate line BGL. The back-gate contact BGC may be disposed on the cell array region CAR of the substrate 100. When viewed in a plan view, the back-gate contact BGC may vertically overlap a region between the data storage patterns DSP. The back-gate contact BGC may be disposed in a region that vertically overlaps a region in which the data storage patterns DSP are arranged in an array shape.

A third spacer 133 may be conformally formed on (e.g., disposed to conformally enclose) a side surface of the back-gate contact BGC. A bottom surface of the third spacer 133 may be in contact with the top surfaces of the back-gate line BGL and the back-gate insulating pattern 110. In other words, the lowermost end of the back-gate contact BGC may not be enclosed by the third spacer 133. The lowermost end of the back-gate contact BGC may be in (e.g., may penetrate) at least a portion of the back-gate line BGL and may be in contact with the back-gate line BGL. The back-gate contact BGC may be electrically isolated (e.g., electrically disconnected) from the shielding structure SM and the bit line BL by the third spacer 133.

The word line contact WC, the bit line contact BC, and the back-gate contact BGC may be formed of or include at least one of various conductive or metallic materials. The first spacer 131, the second spacer 132, and the third spacer 133 may be formed of or include at least one of various insulating materials (e.g., silicon oxide, silicon nitride, and/or silicon oxynitride).

Cell bonding pads 145 may be disposed on the first interlayer insulating layer 130. The peripheral circuit structure PS may be electrically connected to the cell structure CS through the cell bonding pads 145. The cell bonding pads 145 may be disposed in the second interlayer insulating layer 140. The second interlayer insulating layer 140 may be provided to expose (i.e., to not cover) top surfaces of the cell bonding pads 145. A top surface CSa of the second interlayer insulating layer 140 may be referred to as the top surface CSa of the cell structure CS, and the top surface CSa of the cell structure CS may be coplanar with the top surfaces of the cell bonding pads 145. The cell bonding pads 145 may be in contact (i.e., direct, physical contact) with, and electrically connected to, the top surfaces of the word line contact WC, the bit line contact BC, and the back-gate contact BGC, respectively. In some embodiments, first ones of the cell bonding pads 145 may be electrically connected to the word line contacts WC, second ones of the cell bonding pads 145 may be electrically connected to the bit line contacts BC, and third ones of the cell bonding pads 145 may be electrically connected to the back-gate contacts BGC. The cell bonding pads 145 may be formed of or include at least one of various metallic materials (e.g., copper (Cu), tungsten (W), aluminum (Al), nickel (Ni), or tin (Sn)). In an embodiment, the cell bonding pads 145 may be formed of or include copper (Cu).

For a DRAM device of the vertical channel structure (VCT), a connection or extension region may be used to connect the word and bit lines, WL and BL, to a core device, which is configured to drive them. For example, it may be necessary to extend interconnection lines for the word and bit lines, WL and BL, to the connection region and to form contact plugs thereon. This may lead to technical issues, such as the need for additional layers to extend the interconnection lines and an increase in the size of the semiconductor device. In addition, the presence of the additional interconnection lines may result in deterioration of electrical and reliability characteristics of the semiconductor device.

According to an embodiment of the inventive concept, the word line contact WC, the bit line contact BC, and the back-gate contact BGC, which are connected (e.g., electrically connected) to the word line WL, the bit line BL, and the back-gate line BGL, respectively, may be disposed in the cell array region CAR. In other words, it is unnecessary to form an additional interconnection layer, which are used to connect the lines WL, BL, and BGL to the core device, in a connection region. That is, it may be possible to omit the connection region and the additional interconnection layer, to reduce the size of the semiconductor device, and to reduce the cost required to fabricate the semiconductor device. In addition, due to the absence of the additional interconnection layer, it may be possible to improve the electrical and reliability of characteristics of the semiconductor device. Furthermore, the inventive concept is not limited to the VCT-type DRAM device.

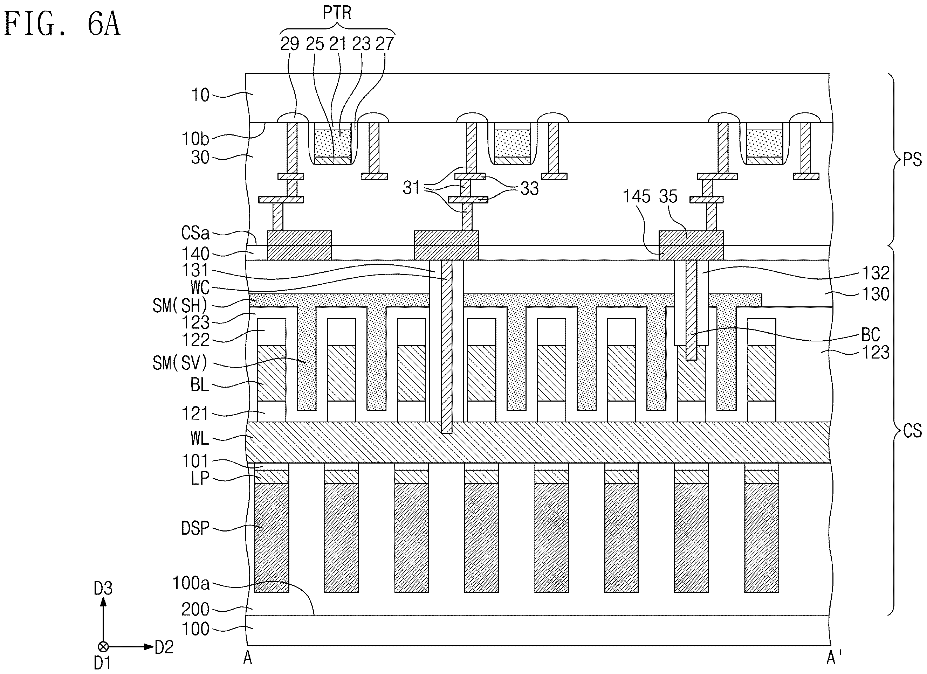

FIGS. 6A to 8B are sectional views illustrating a semiconductor device according to an embodiment of the inventive concept. For concise description, a previously described element may be identified by the same reference number without repeating an overlapping description thereof.

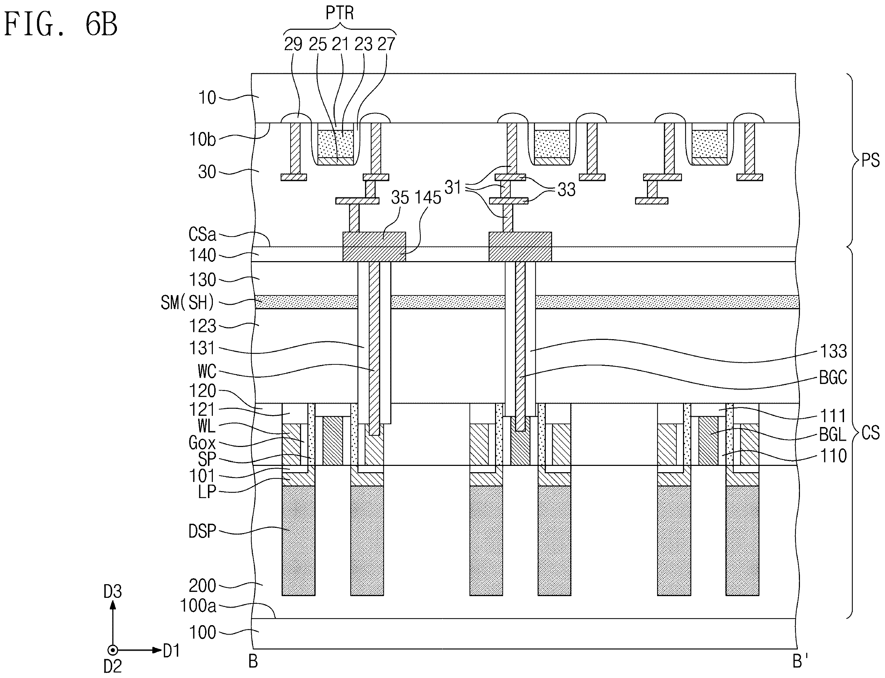

Referring to FIGS. 6A and 6B, the cell structure CS may be disposed on the substrate 100, and the peripheral circuit structure PS may be disposed on the cell structure CS. The cell structure CS may have substantially the same structural features as those in FIGS. 5A and 5B.

The peripheral circuit structure PS may include a peripheral substrate 10, peripheral circuit transistors PTR and peripheral contact plugs 31, which are placed on a bottom surface 10b of a peripheral substrate 10, peripheral circuit interconnection lines 33, which are electrically connected to the peripheral circuit transistors PTR through the peripheral contact plugs 31, and a first insulating layer 30, which is provided on (e.g., to enclose) them.

The peripheral circuit transistors PTR, the peripheral contact plugs 31, and the peripheral circuit interconnection lines 33 may constitute a peripheral circuit. Each of the peripheral circuit transistors PTR may include a peripheral gate insulating layer 21, a peripheral gate electrode 23, a peripheral capping pattern 25, a peripheral gate spacer 27, and peripheral source/drain regions 29.

The peripheral gate insulating layer 21 may be disposed between the peripheral gate electrode 23 and the peripheral substrate 10. The peripheral capping pattern 25 may be disposed on the peripheral gate electrode 23. The peripheral gate spacer 27 may be on (e.g., may cover) side surfaces of the peripheral gate insulating layer 21, the peripheral gate electrode 23, and the peripheral capping pattern 25. The peripheral source/drain regions 29 may be provided in portions of the peripheral substrate 10, which are located at opposite sides of the peripheral gate electrode 23.

The peripheral circuit interconnection lines 33 may be electrically connected to the peripheral circuit transistors PTR through the peripheral contact plugs 31. In an embodiment, each of the peripheral circuit transistors PTR may be an NMOS transistor, a PMOS transistor, or a gate-all-around-type transistor. The peripheral contact plugs 31 and the peripheral circuit interconnection lines 33 may be formed of or include at least one of various conductive materials (e.g., metallic materials).

The first insulating layer 30 may be provided on the bottom surface 10b of the peripheral substrate 10. The first insulating layer 30 on the peripheral substrate 10 may be on (e.g., may cover) the peripheral circuit transistors PTR, the peripheral contact plugs 31, and the peripheral circuit interconnection lines 33. The first insulating layer 30 may be provided to have a multi-layered structure including a plurality of insulating layers. For example, the first insulating layer 30 may be formed of or include at least one of silicon oxide, silicon nitride, silicon oxynitride, and/or low-k dielectric materials.

Upper bonding pads 35 may be disposed such that they are electrically connected to the peripheral circuit transistors PTR through the peripheral contact plugs 31 and the peripheral circuit interconnection lines 33. In an embodiment, the first insulating layer 30 does not cover bottom surfaces of the upper bonding pads 35. A bottom surface of the first insulating layer 30 may be coplanar with the bottom surfaces of the upper bonding pads 35.

The upper bonding pads 35 may be formed of or include at least one of metallic materials (e.g., copper (Cu), tungsten (W), aluminum (Al), nickel (Ni), or tin (Sn)). In an embodiment, the upper bonding pads 35 may be formed of or include copper (Cu).

Top surfaces of the cell bonding pads 145 may be in direct contact with bottom surfaces of the upper bonding pads 35, respectively. The cell bonding pads 145 and the upper bonding pads 35 may form a single object without an interface therebetween. The cell bonding pads 145 and the upper bonding pads 35 are illustrated to have side surfaces that are aligned to each other, but the inventive concept is not limited to this example; for example, when viewed in a plan view, the cell bonding pads 145 and the upper bonding pads 35 may have side surfaces that are spaced apart from each other.

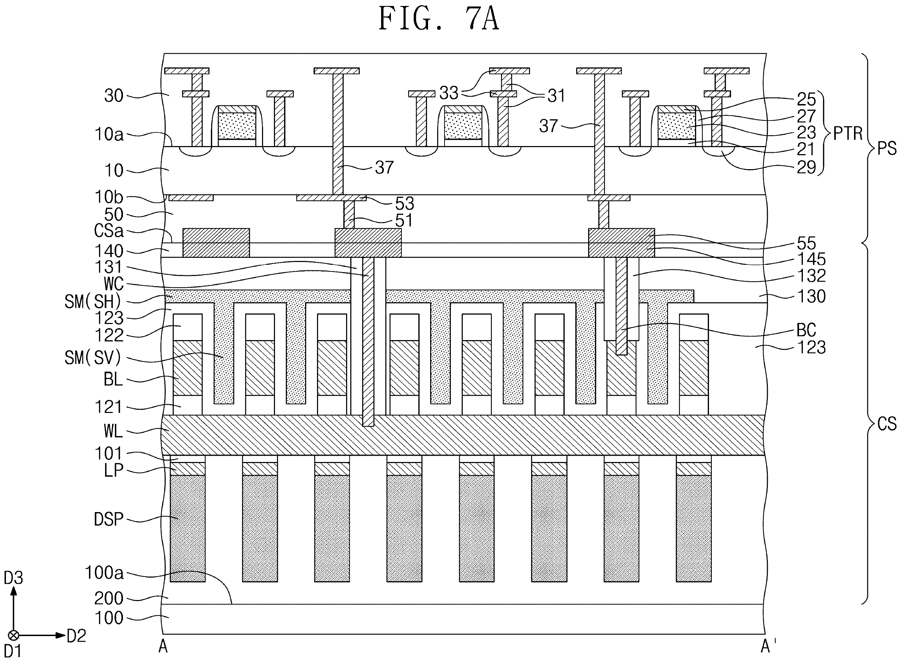

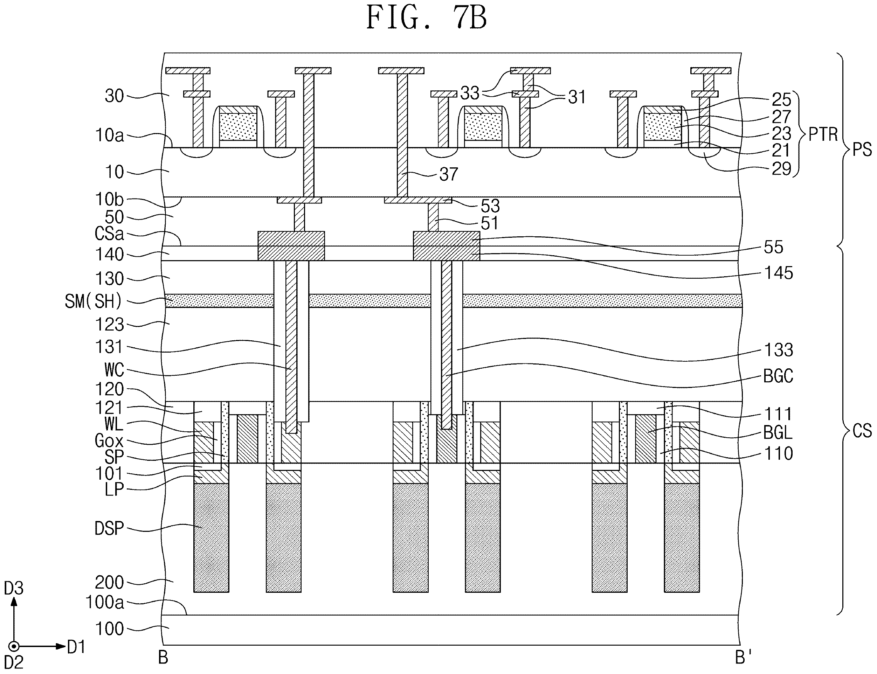

Referring to FIGS. 7A and 7B, the cell structure CS may be disposed on the substrate 100, and the peripheral circuit structure PS may be disposed on the cell structure CS. The cell structure CS may have substantially the same structural features as those in FIGS. 5A and 5B.

The peripheral circuit structure PS may include peripheral penetration contacts 37, which are electrically connected to the peripheral circuit transistors PTR through the peripheral contact plugs 31, and the peripheral circuit interconnection lines 33 on a top surface 10a of the peripheral substrate 10. The peripheral circuit transistors PTR may have substantially the same features as those described with reference to FIGS. 6A and 6B.

A second insulating layer 50 may be disposed on the bottom surface 10b of the peripheral substrate 10. The second insulating layer 50 may include lower contact plugs 51, lower circuit interconnection lines 53, and lower bonding pads 55. A bottom surface of the second insulating layer 50 may not cover bottom surfaces of the lower bonding pads 55. The bottom surface of the second insulating layer 50 may be coplanar with the bottom surfaces of the lower bonding pads 55. The peripheral penetration contacts 37 may be in (e.g., may be provided to penetrate) the peripheral substrate 10 and may be electrically connected to the lower bonding pads 55 through the lower contact plugs 51 and the lower circuit interconnection lines 53.

The lower bonding pads 55 may be formed of or include at least one of various metallic materials (e.g., copper (Cu), tungsten (W), aluminum (Al), nickel (Ni), or tin (Sn)). In an embodiment, the lower bonding pads 55 may be formed of or include copper (Cu).

Top surfaces of the cell bonding pads 145 may be in direct contact with bottom surfaces of the lower bonding pads 55, respectively. The cell bonding pads 145 and the lower bonding pads 55 may be connected to each other, without an interface therebetween, to form a single object. The cell bonding pads 145 and the lower bonding pads 55 are illustrated to have side surfaces that are aligned to each other, but the inventive concept is not limited to this example; for example, when viewed in a plan view, the cell bonding pads 145 and the lower bonding pads 55 may have side surfaces that are spaced apart from each other.

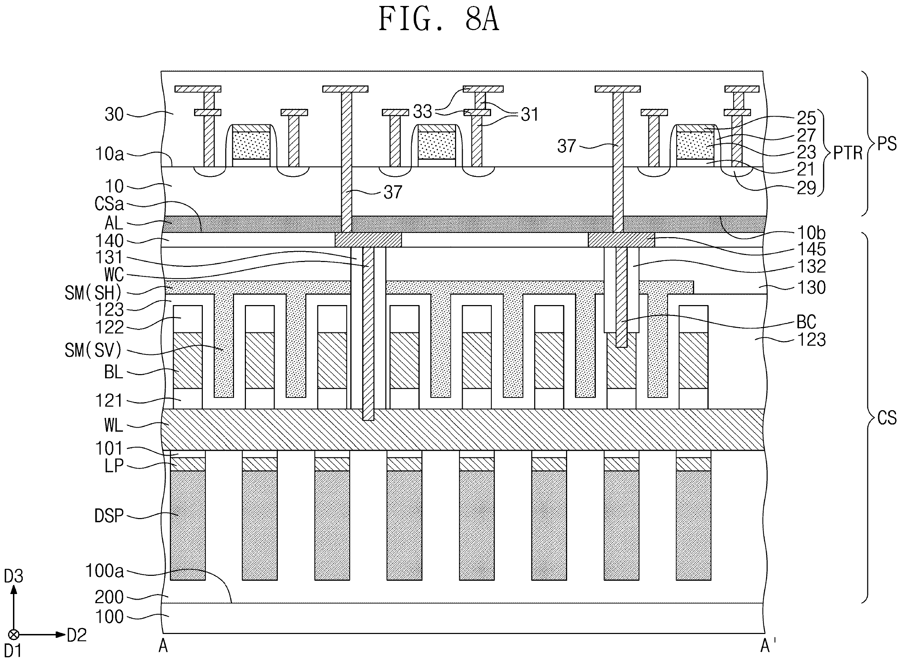

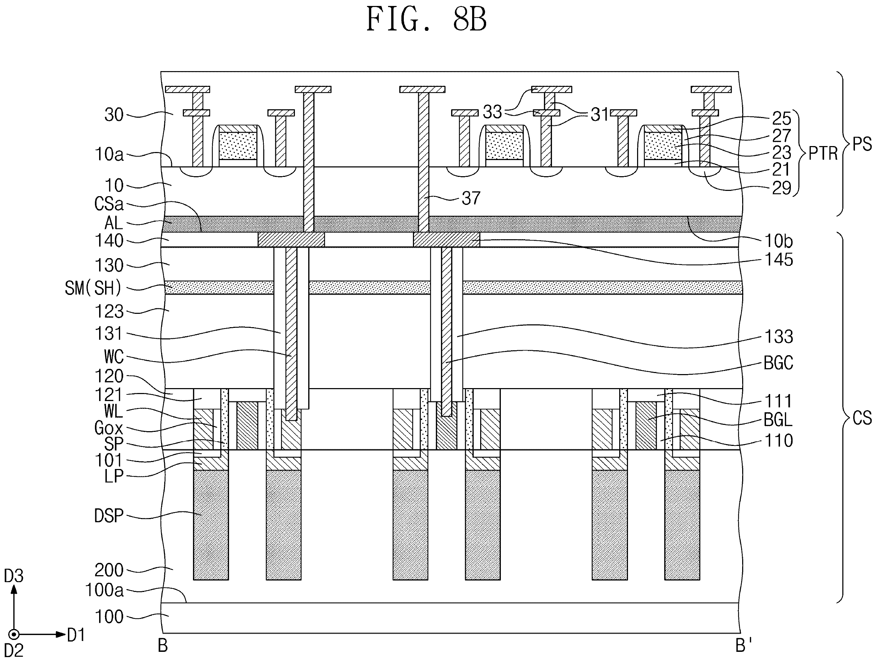

Referring to FIGS. 8A and 8B, the cell structure CS may be disposed on the substrate 100, and the peripheral circuit structure PS may be disposed on the cell structure CS. The cell structure CS may have substantially the same structural features as those in FIGS. 5A and 5B.

The peripheral circuit structure PS may include the peripheral penetration contacts 37, which are electrically connected to the peripheral circuit transistors PTR through the peripheral contact plugs 31, and the peripheral circuit interconnection lines 33 on the top surface 10a of the peripheral substrate 10. The peripheral circuit transistors PTR may have substantially the same features as those described with reference to FIGS. 6A and 6B.

An interface layer AL may be disposed on the top surface CSa of the cell structure CS. The interface layer AL may be interposed between the cell structure CS and the peripheral circuit structure PS. The peripheral penetration contacts 37 may be in (e.g., may be provided to penetrate) the interface layer AL and may be electrically connected to the cell bonding pads 145 of the cell structure CS.

The interface layer AL may have a single- or multi-layered structure, which may be formed of at least one of SiCN or silicon oxide. In an embodiment, the formation of the interface layer AL may include forming a first interface layer (not shown) on the top surface CSa of the cell structure CS and forming a second interface layer (not shown) on a bottom surface of the peripheral substrate 10. A plasma treatment step may be performed on surfaces of the first and second interface layers to remove the -CN group at ends of the SiCN layer and form dangling bonds. A deionized water treatment step may be performed on the surfaces of the first and second interface layers to form the -OH group on the dangling bond. The first and second interface layers may be placed to be in contact with each other, and then, a thermocompression process may be performed thereon. As a result of the thermocompression process, the -OH groups at interfaces between the first and second interface layers may combine to form H₂O, and the remaining -O- groups may combine with adjacent Si to form a SiO₂ layer between the first and second interface layers. Thus, the peripheral circuit structure PS may be bonded to the top surface CSa of the cell structure CS, and the interface layer AL may be formed between them. The interface layer AL may have a triple layer structure in which a SiCN layer, a SiO₂ layer, and a SiCN layer are sequentially stacked.

Although not shown, an insulating layer (not shown) may be interposed between the side surfaces of the peripheral penetration contacts 37 and the peripheral substrate 10. Thus, the peripheral penetration contacts 37 may be electrically isolated (e.g., electrically disconnected) from the peripheral substrate 10. For example, the insulating layer (not shown) may be formed in the peripheral substrate 10 before the formation of the peripheral penetration contacts 37, and in this case, it may be possible to reduce a failure rate and a process burden in a fabrication process, compared with a method of forming an insulating layer to fully cover the side surfaces of the peripheral penetration contacts 37.

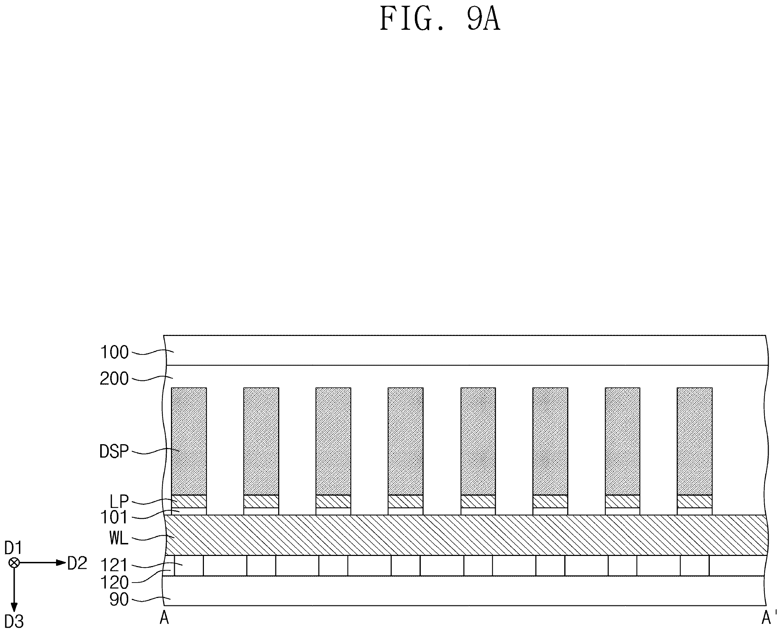

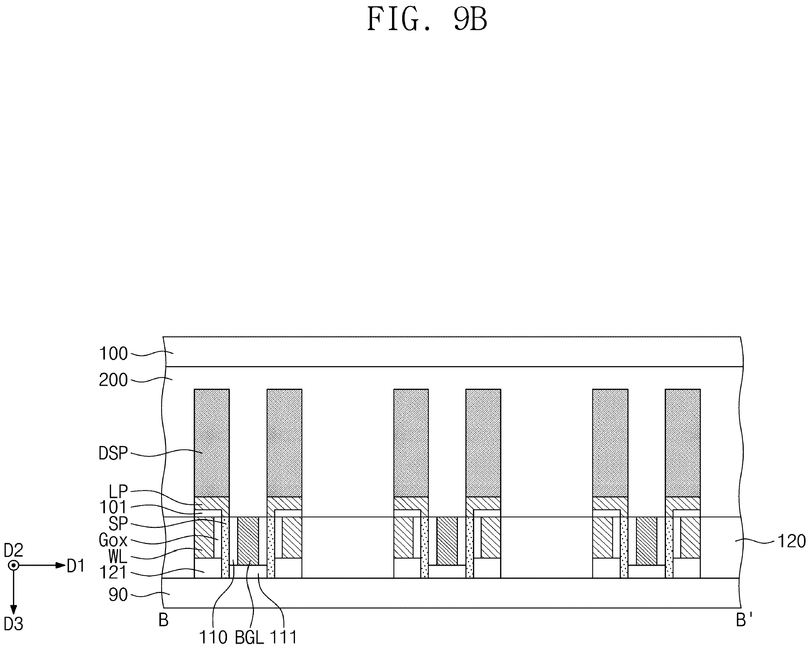

FIGS. 9A, 10A, 11A, 12A, and 13A are sectional views illustrating a method of fabricating a semiconductor device, according to an embodiment of the inventive concept, and corresponding to the line A-A' of FIG. 4. FIGS. 9B, 10B, 11B, 12B, and 13B are sectional views illustrating a method of fabricating a semiconductor device, according to an embodiment of the inventive concept, and corresponding to the line B-B' of FIG. 4. For concise description, a previously described element may be identified by the same reference number without repeating an overlapping description thereof.

Referring to FIGS. 9A and 9B, the first insulating pattern 120, the second capping pattern 121, the back-gate capping pattern 111, the gate insulating pattern Gox, the semiconductor pattern SP, the back-gate insulating pattern 110, the word line WL, and the back-gate line BGL may be formed on a preliminary substrate 90. The formation of the first insulating pattern 120, the second capping pattern 121, the back-gate capping pattern 111, the gate insulating pattern Gox, the semiconductor pattern SP, the back-gate insulating pattern 110, the word line WL, and the back-gate line BGL may be achieved using a process (e.g., a chemical vapor deposition (CVD) process or a physical vapor deposition (PVD) process) of forming a layer on a desired region using a mask pattern. In addition, an etching process using a mask pattern as an etch mask may be further performed.

The first capping pattern 101, the landing pad LP, the data storage pattern DSP, and the lower insulating layer 200 may be formed on the first insulating pattern 120, the second capping pattern 121, the back-gate capping pattern 111, the gate insulating pattern Gox, the semiconductor pattern SP, the back-gate insulating pattern 110, the word line WL, and the back-gate line BGL. The formation of the first capping pattern 101, the landing pad LP, the data storage pattern DSP, and the lower insulating layer 200 may be achieved using a process (e.g., a chemical vapor deposition (CVD) process or a physical vapor deposition (PVD) process) of forming a layer on a desired region using a mask pattern. In addition, an etching process using a mask pattern as an etch mask may be further performed.

The substrate 100 may be formed on the lower insulating layer 200. The substrate 100 may be a silicon substrate, but the inventive concept is not limited to this example.

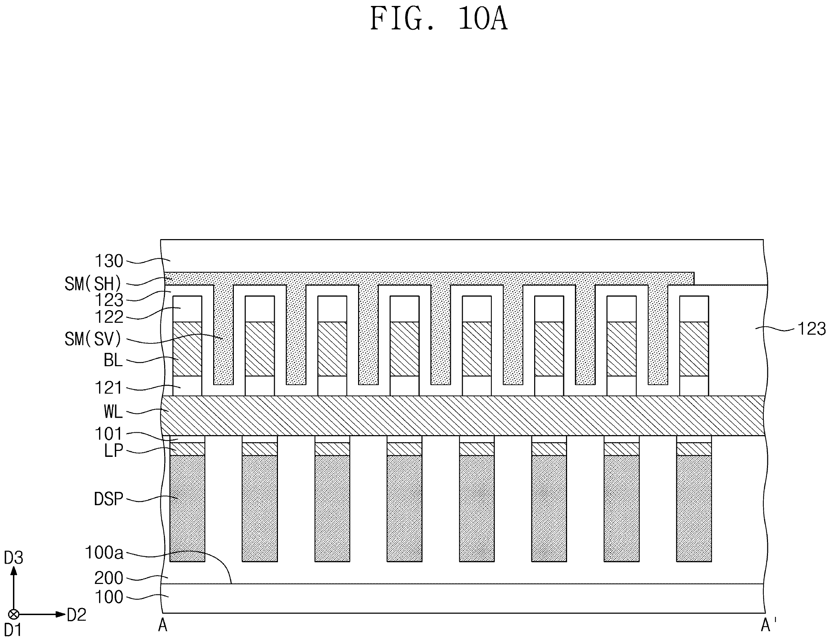

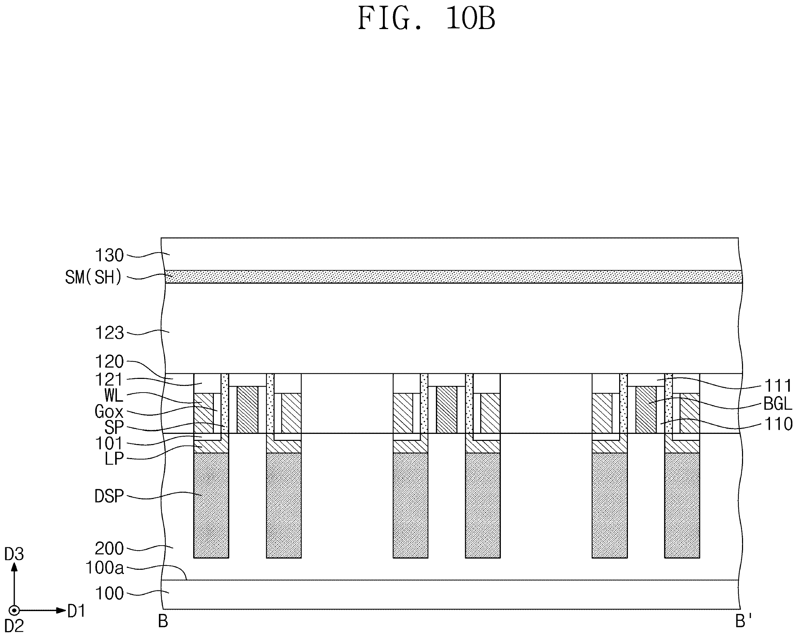

Referring to FIGS. 10A and 10B, the structure of FIGS. 9A and 9B may be inverted. The preliminary substrate 90 may be removed from the inverted structure. In an embodiment, the preliminary substrate 90 may be removed by a chemical mechanical polishing (CMP) process.

The bit line BL may be formed on the second capping pattern 121. The capping layer 122 may be formed on the bit line BL. In an embodiment, the formation of the bit line BL may include forming a bit line layer (not shown), forming a mask pattern (not shown) on the bit line layer, patterning the bit line layer using the mask pattern as an etch mask, and removing the mask pattern. In an embodiment, a plurality of bit lines BL may be formed. The bit lines BL may be formed to be in contact with corresponding ones of the semiconductor patterns SP. The capping layer 122 may be formed by substantially the same method as that used for the bit line BL.

The second insulating pattern 123 may be conformally formed on (e.g., to cover conformally) the second capping pattern 121, the bit line BL, and the capping layer 122. The formation of the second insulating pattern 123 may be performed using a layer-forming process (e.g., chemical vapor deposition (CVD), physical vapor deposition (PVD), or atomic layer deposition (ALD)) process) having a good step-coverage property.

The shielding structure SM may be formed on the second insulating pattern 123. The shielding structure SM may include the vertical portions SV and the horizontal portion SH. The vertical portions SV of the shielding structure SM may be interposed between the second insulating patterns 123, and the horizontal portion SH of the shielding structure SM may extend to a region on a top surface of the second insulating pattern 123. In an embodiment, the formation of the shielding structure SM may include forming a shielding structure layer (not shown) and planarizing an upper portion of the shielding structure layer. The formation of the shielding structure layer may be achieved using a layer-forming process (e.g., chemical vapor deposition (CVD), physical vapor deposition (PVD), or atomic layer deposition (ALD)) having a good step-coverage property. In an embodiment, the planarization process may include a chemical mechanical polishing (CMP) process or an etch-back process.

The first interlayer insulating layer 130 may be formed on the second insulating pattern 123 and the shielding structure SM. The formation of the first interlayer insulating layer 130 may be achieved using a layer-forming process (e.g., chemical vapor deposition (CVD) or physical vapor deposition (PVD)).

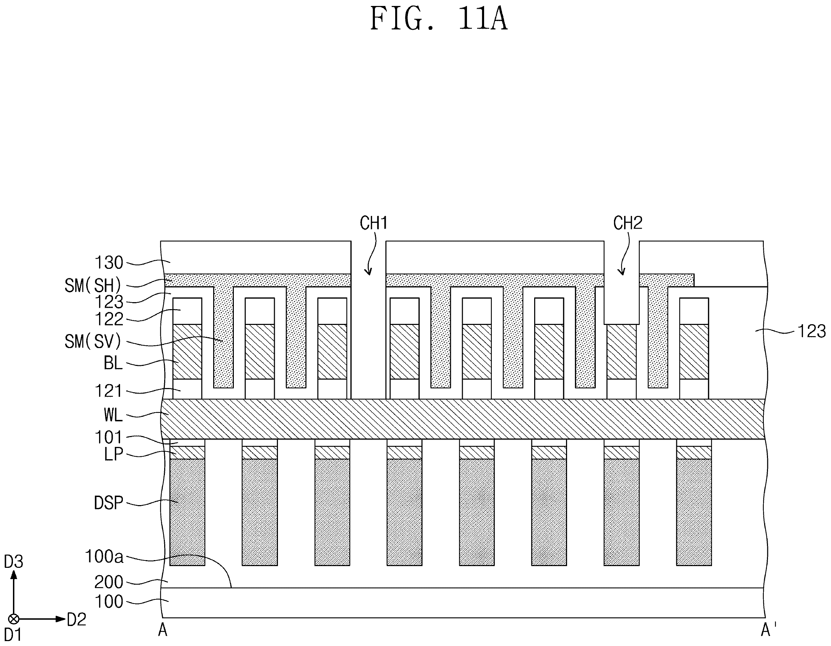

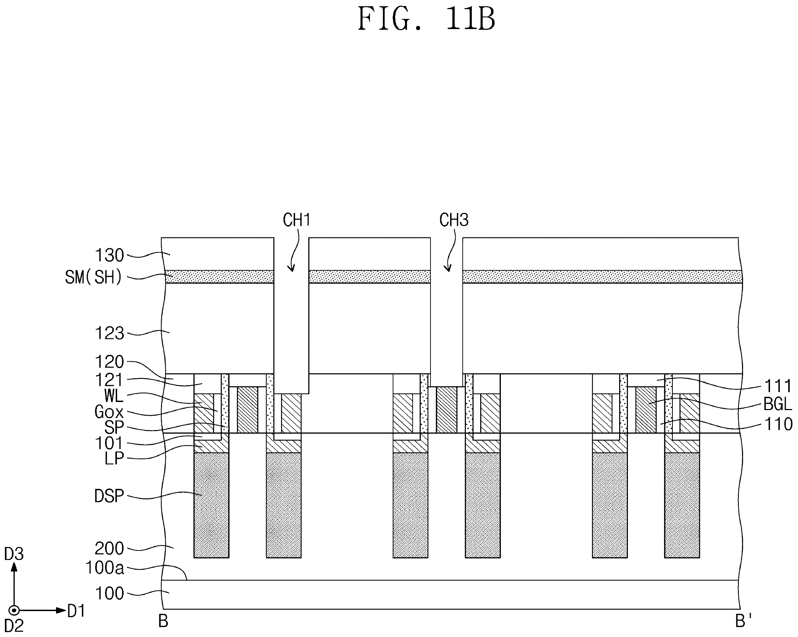

Referring to FIGS. 11A and 11B, a first contact hole CH1 may be formed in (e.g., to penetrate) the first interlayer insulating layer 130, the shielding structure SM, the second insulating pattern 123, and the second capping pattern 121. In an embodiment, the formation of the first contact hole CH1 may include forming a mask pattern (not shown) on the first interlayer insulating layer 130, etching the first interlayer insulating layer 130, the shielding structure SM, the second insulating pattern 123, and the second capping pattern 121 using the mask pattern as an etch mask, and removing the mask pattern. The first contact hole CH1 may expose a top surface of the word line WL corresponding thereto. A portion of the first insulating pattern 120 in contact with the word line WL may be further etched in the process of forming the first contact hole CH1.

A second contact hole CH2 may be formed in (e.g., to penetrate) the first interlayer insulating layer 130, the capping layer 122, the horizontal portion SH of the shielding structure SM and in (e.g., to penetrate) a portion of the second insulating pattern 123 in the vertical depth. The formation of the second contact hole CH2 may be achieved by substantially the same method as that used for the first contact hole CH1. The second contact hole CH2 may expose a top surface of the bit line BL corresponding thereto.

A third contact hole CH3 may be formed in (e.g., to penetrate) the first interlayer insulating layer 130, the shielding structure SM, the second insulating pattern 123, and the back-gate capping pattern 111. The formation of the third contact hole CH3 may be achieved by substantially the same method as that used for the first contact hole CH1. The third contact hole CH3 may be formed to expose a top surface of a corresponding one of the back-gate lines BGL.

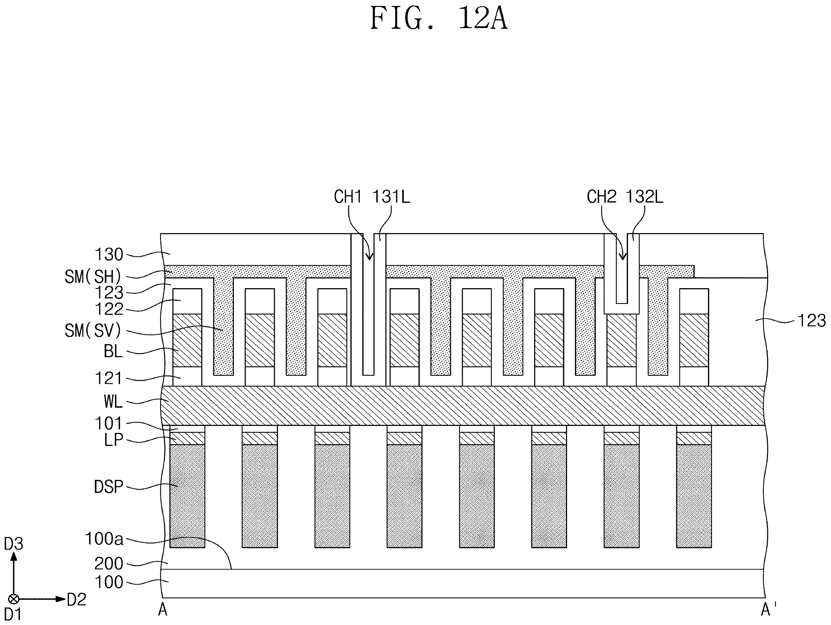

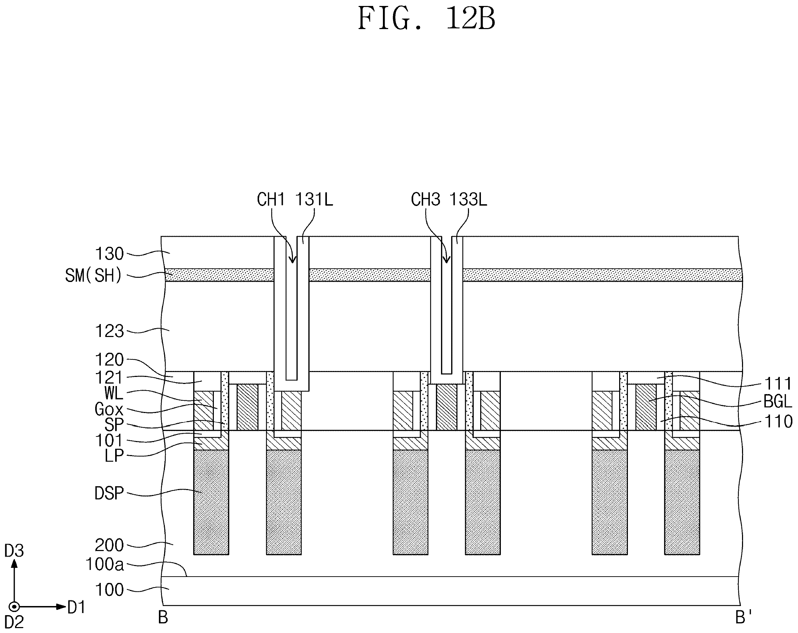

Referring to FIGS. 12A and 12B, a first spacer layer 131L may be conformally formed on (e.g., to conformally cover) a side surface of the first contact hole CH1. The formation of the first spacer layer 131L may be achieved using a layer-forming process (e.g., chemical vapor deposition (CVD), physical vapor deposition (PVD), or atomic layer deposition (ALD)) having a good step-coverage property.

A second spacer layer 132L may be conformally formed on (e.g., to conformally cover) a side surface of the second contact hole CH2, and a third spacer layer 133L may be conformally formed on (e.g., to conformally cover) a side surface of the third contact hole CH3. The formation of the second and third spacer layers 132L and 133L may be achieved by substantially the same method as that used for the first spacer layer 131L.

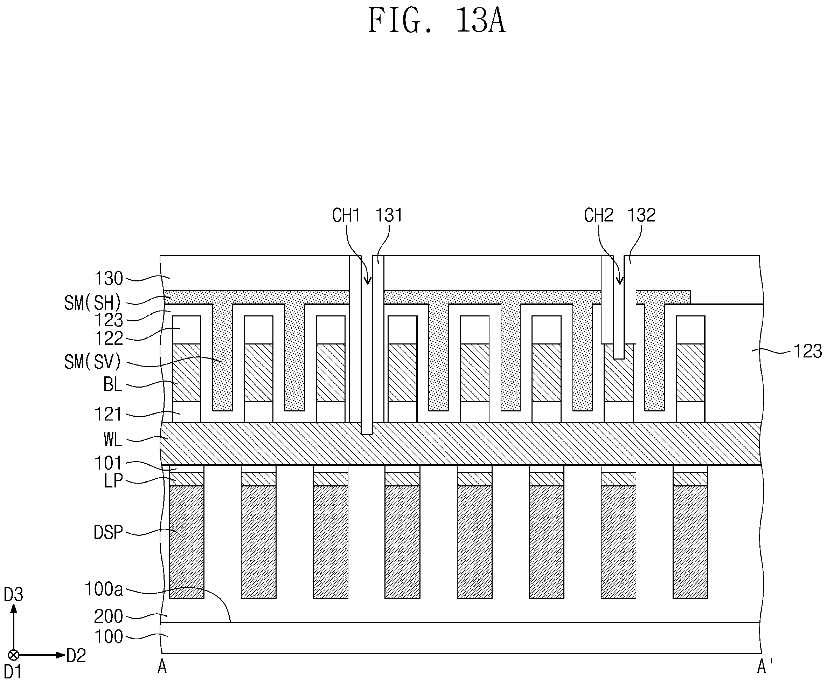

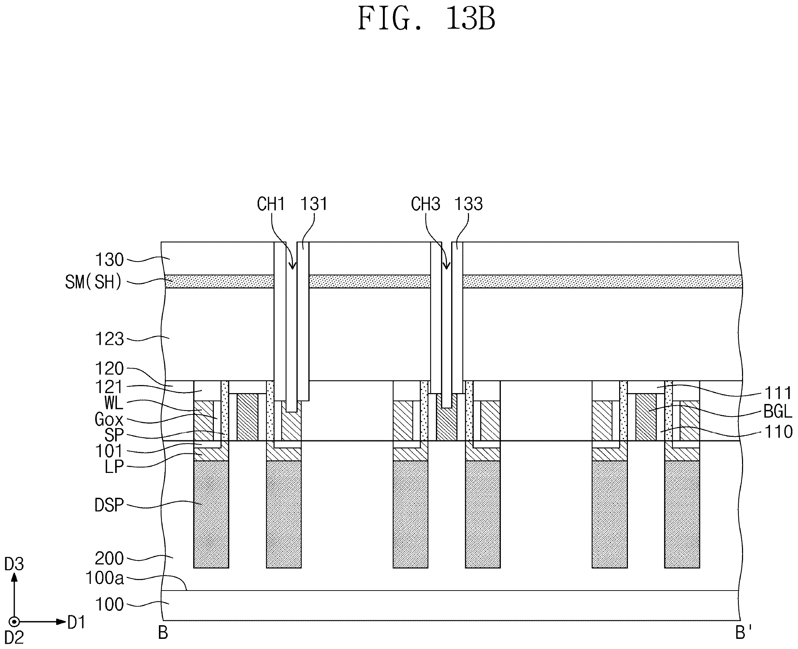

Referring to FIGS. 13A and 13B, a top surface of the word line WL may be recessed through the first contact hole CH1, and in this case, the lowermost end of the first contact hole CH1 may be placed within the word line WL. This process may include anisotropically etching the lowermost end of the first spacer layer 131L and a portion of the top surface of the word line WL through a remaining portion of the first contact hole CH1. A bottom surface of the first contact hole CH1 may be lower than the top surface of the word line WL. As a result of the etching of the lowermost end of the first spacer layer 131L, the first spacer 131 may be formed.

A top surface of the bit line BL may be recessed through the second contact hole CH2, and in this case, the lowermost end of the second contact hole CH2 may be placed within the bit line BL. This process may be performed by anisotropically etching the lowermost end of the second spacer layer 132L and a portion of the top surface of the bit line BL through a remaining portion of the second contact hole CH2. A bottom surface of the second contact hole CH2 may be lower than the top surface of the bit line BL. As a result of the etching of the lowermost end of the second spacer layer 132L, the second spacer 132 may be formed.

A top surface of the back-gate line BGL may be recessed through the third contact hole CH3, and in this case, the lowermost end of the third contact hole CH3 may be placed within the back-gate line BGL. This process may be performed by anisotropically etching the lowermost end of the third spacer layer 133L and a portion of the top surface of the back-gate line BGL through a remaining portion of the third contact hole CH3. A bottom surface of the third contact hole CH3 may be lower than the top surface of the back-gate line BGL. As a result of the etching of the lowermost end of the third spacer layer 133L, the third spacer 133 may be formed.

Referring back to FIGS. 5A and 5B, the word line contact WC may be formed in (e.g., to fill) a remaining portion of the first contact hole CH1. The bit line contact BC and the back-gate contact BGC may be formed in (e.g., to fill) the remaining portions of the second and third contact holes CH2 and CH3, respectively. In an embodiment, the formation of the word line contact WC, the bit line contact BC, and the back-gate contact BGC may include forming a word line contact layer (not shown), a bit line contact layer (not shown), and a back-gate contact layer (not shown) and performing a planarization process to expose a top surface of the first interlayer insulating layer 130.

The cell bonding pads 145 may be formed on the word line contact WC, the bit line contact BC, and the back-gate contact BGC, respectively. In an embodiment, the formation of the cell bonding pads 145 may include forming a cell bonding layer (not shown) on the first interlayer insulating layer 130, forming a mask pattern (not shown) on the cell bonding layer, patterning the cell bonding layer using the mask pattern as an etch mask, and removing the mask pattern.

The second interlayer insulating layer 140 may be formed on the first interlayer insulating layer 130. The second interlayer insulating layer 140 may expose (i.e., may not cover) the top surfaces of the cell bonding pads 145.

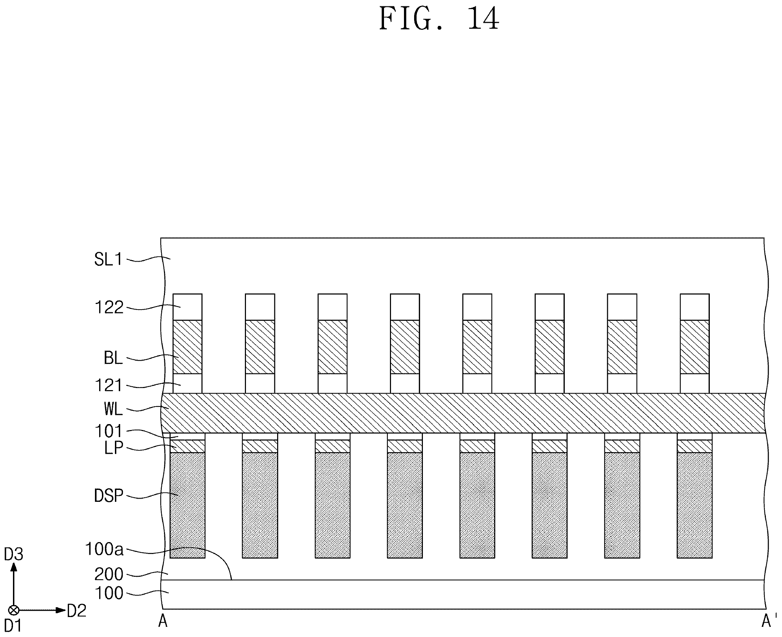

FIGS. 14 to 19 are sectional views illustrating a method of fabricating a semiconductor device, according to an embodiment of the inventive concept, and corresponding to the line A-A' of FIG. 4. For concise description, a previously described element may be identified by the same reference number without repeating an overlapping description thereof.

Referring to FIG. 14, the lower insulating layer 200, the data storage pattern DSP, the landing pad LP, the first capping pattern 101, the word line WL, the second capping pattern 121, the bit line BL, the capping layer 122, and a first sacrificial layer SL1 may be formed on the substrate 100. In an embodiment, the gate insulating pattern Gox, the semiconductor pattern SP, the back-gate line BGL, the back-gate insulating pattern 110, the back-gate capping pattern 111, and the first insulating pattern 120 may be formed, although not shown. This may be performed by substantially the same method as that in FIGS. 9A and 9B. The first sacrificial layer SL1 may be formed of or include a material having an etch selectivity with respect to the lower insulating layer 200, the first capping pattern 101, the word line WL, the bit line BL, the second capping pattern 121, and the capping layer 122.

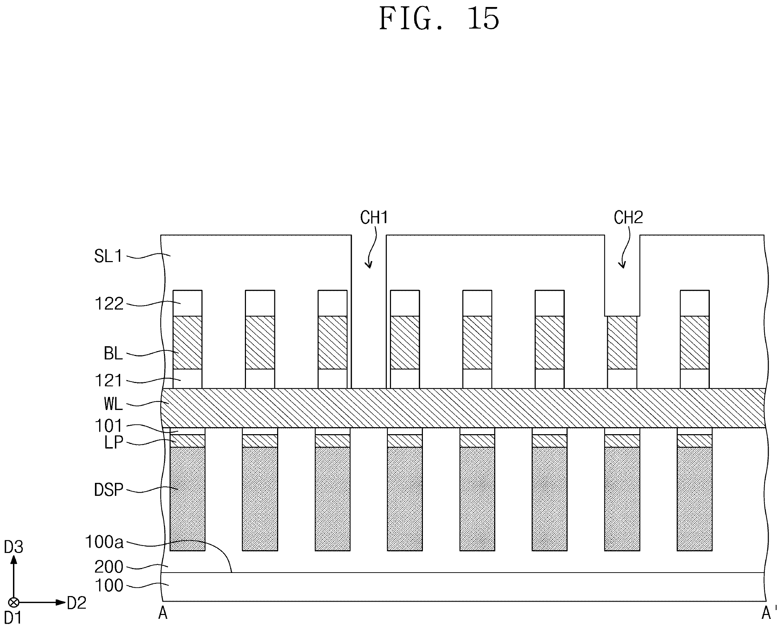

Referring to FIG. 15, the first contact hole CH1 may be formed in (e.g., to penetrate) the first sacrificial layer SL1, the capping layer 122, the bit line BL, and the second capping pattern 121. The first contact hole CH1 may expose a top surface of the word line WL corresponding thereto. The second contact hole CH2 may be formed in (e.g., to penetrate) the first sacrificial layer SL1 and the capping layer 122. The second contact hole CH2 may expose a top surface of the bit line BL corresponding thereto.

The formation of the first and second contact holes CH1 and CH2 may be achieved by substantially the same method as that used to form the first and second contact holes CH1 and CH2 in the previous embodiment of FIGS. 11A and 11B.

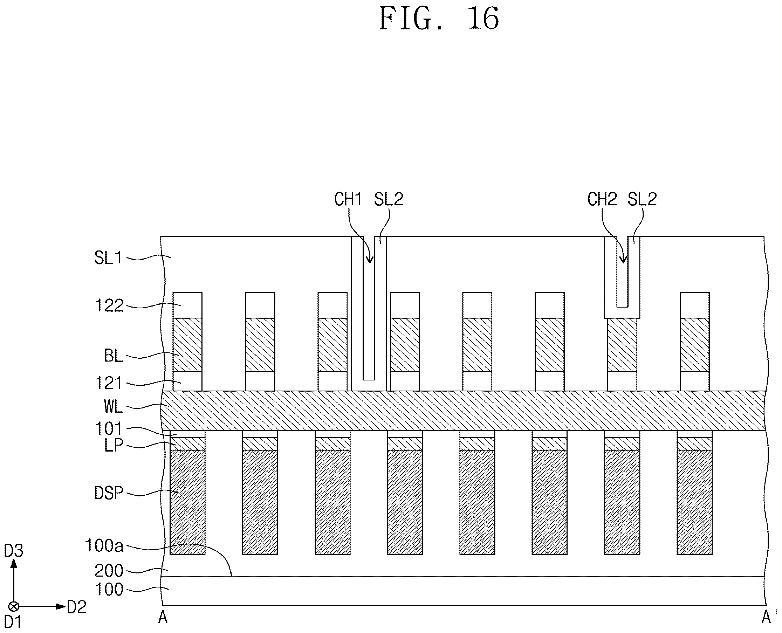

Referring to FIG. 16, second sacrificial layers SL2 may be conformally formed on (e.g., to conformally cover) side surfaces of the first and second contact holes CH1 and CH2. The formation of the second sacrificial layers SL2 may be achieved by substantially the same method as that used to form the first spacer layer 131L in the previous embodiment of FIGS. 12A and 12B. The second sacrificial layer SL2 may be formed of or include a material having an etch selectivity with respect to the lower insulating layer 200, the first capping pattern 101, the word line WL, the bit line BL, the second capping pattern 121, and the capping layer 122.

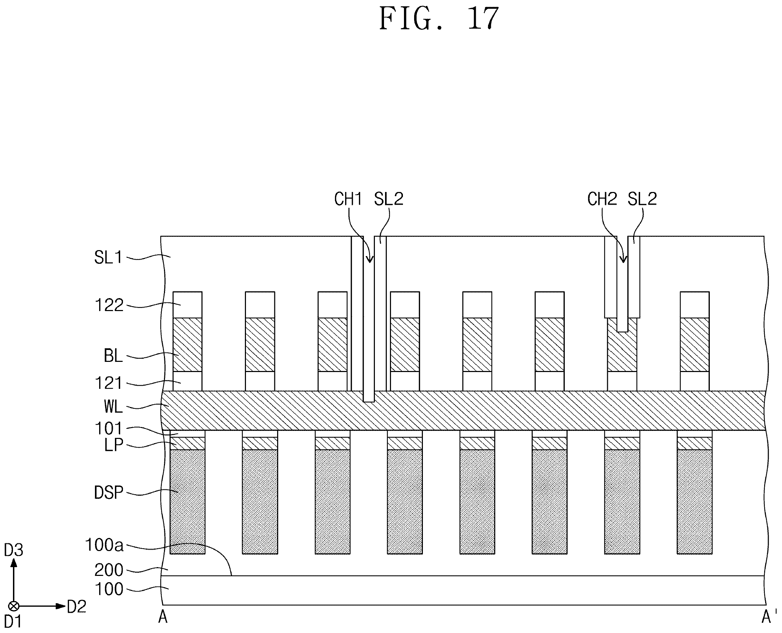

Referring to FIG. 17, a top surface of the word line WL may be recessed through the first contact hole CH1, and in this case, the lowermost end of the first contact hole CH1 may be placed within the word line WL. A top surface of the bit line BL may be recessed through the second contact hole CH2, and in this case, the lowermost end of the second contact hole CH2 may be placed within the bit line BL. This may be performed by substantially the same method as that in the embodiment described with reference to FIGS. 13A and 13B.

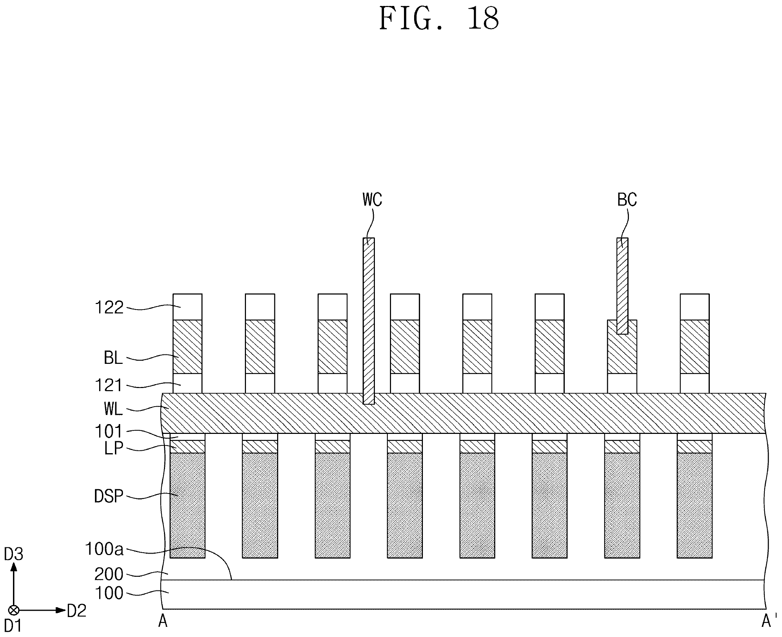

Referring to FIG. 18, the word line contact WC and the bit line contact BC may be formed in (e.g., to fill) the first and second contact holes CH1 and CH2. The formation of the word line contact WC and the bit line contact BC may be achieved by substantially the same method as that described with reference to FIGS. 5A and 5B.

The first and second sacrificial layers SL1 and SL2 may be selectively removed, after the formation of the word line contact WC and the bit line contact BC. In an embodiment, the removal of the first and second sacrificial layers SL1 and SL2 may be performed through a wet etching process. The lower insulating layer 200, the first capping pattern 101, the word line WL, the bit line BL, the second capping pattern 121, the capping layer 122, the word line contact WC, and the bit line contact BC may not be removed, during the removal of the first and second sacrificial layers SL1 and SL2.

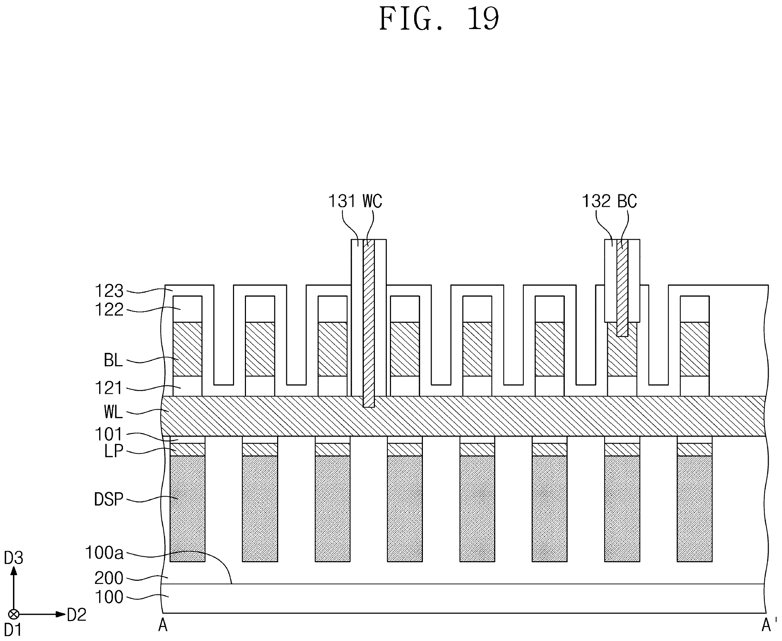

Referring to FIG. 19, the second insulating pattern 123, the first spacer 131, and the second spacer 132 may be formed. The second insulating pattern 123 may be conformally formed on (e.g., may conformally cover) the second capping pattern 121, the bit line BL, and the capping layer 122. The formation of the second insulating pattern 123 may be achieved by substantially the same method as that described with reference to FIGS. 10A and 10B.

The first spacer 131 may be conformally formed on (e.g., may conformally cover) a side surface of the word line contact WC. The second spacer 132 may be conformally formed on (e.g., may conformally cover) a side surface of the bit line contact BC. In an embodiment, the formation of the first and second spacers 131 and 132 may include forming a mask pattern (not shown), forming the first and second spacers 131 and 132, and removing the mask pattern.

Referring back to FIGS. 5A and 5B, the shielding structure SM may be formed. The formation of the shielding structure SM may be achieved by substantially the same method as that described with reference to FIGS. 10A and 10B.

The first interlayer insulating layer 130 may be formed on the second insulating pattern 123 and the shielding structure SM. In an embodiment, the first interlayer insulating layer 130 may be formed using a layer-forming process (e.g., chemical vapor deposition (CVD) or physical vapor deposition (PVD)). The cell bonding pads 145 may be respectively formed on the word line contact WC and the bit line contact BC. In an embodiment, the formation of the cell bonding pads 145 may include forming a cell bonding layer (not shown) on the first interlayer insulating layer 130, forming a mask pattern (not shown) on the cell bonding layer, patterning the cell bonding layer using the mask pattern as an etch mask, and removing the mask pattern.

The second interlayer insulating layer 140 may be formed on the first interlayer insulating layer 130. The second interlayer insulating layer 140 may be formed to expose the top surfaces of the cell bonding pads 145.

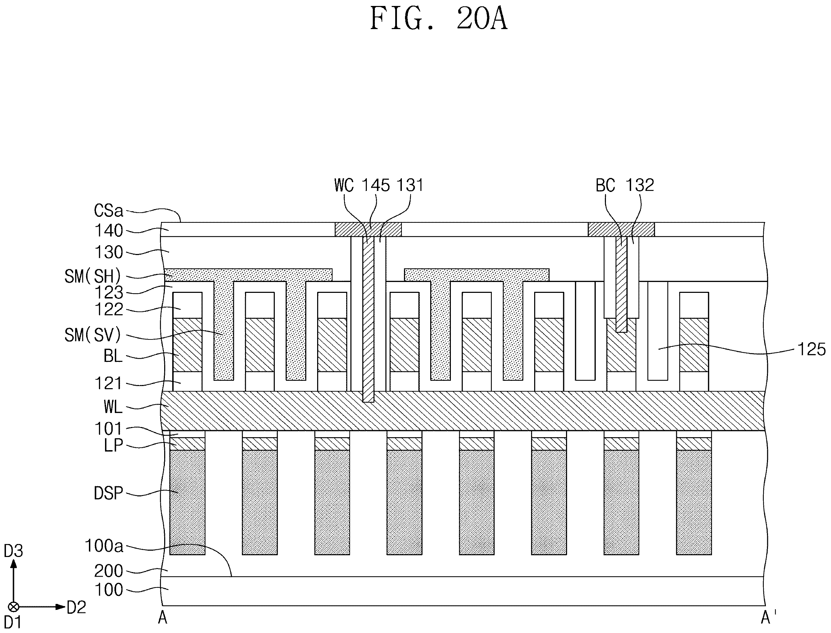

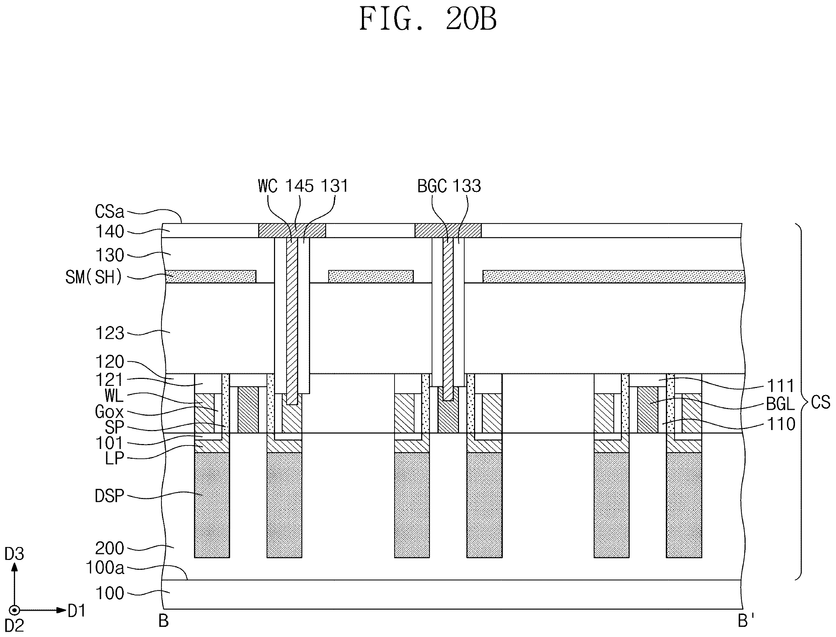

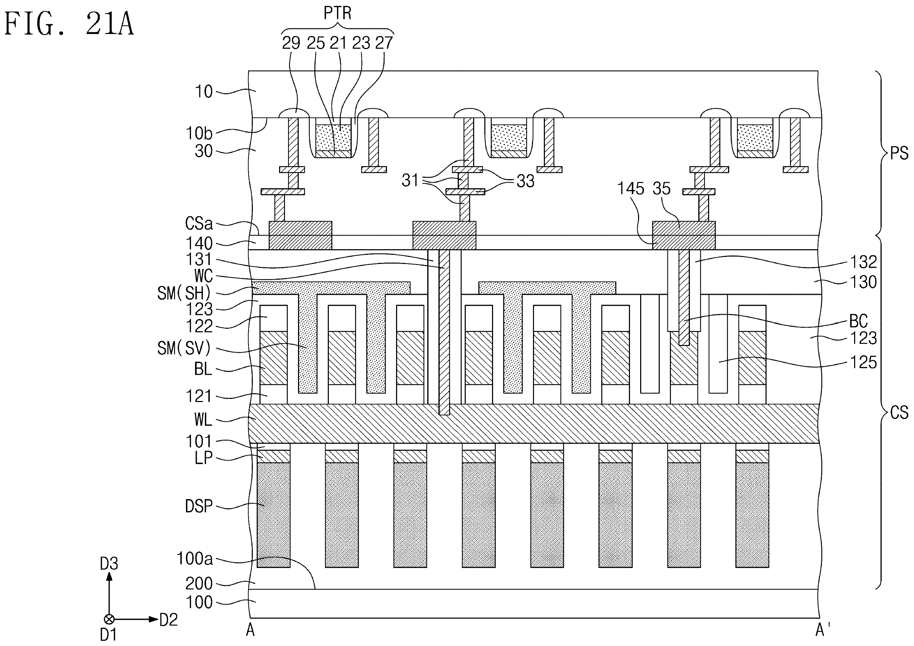

FIGS. 20A and 20B are sectional views illustrating a semiconductor device according to an embodiment of the inventive concept and corresponding to the line A-A' of FIG. 4. FIGS. 21A to 23B are sectional views illustrating a semiconductor device according to an embodiment of the inventive concept. For concise description, a previously described element may be identified by the same reference number without repeating an overlapping description thereof.

Referring to FIGS. 20A and 20B, the cell structure CS may be disposed on the substrate 100. The cell structure CS in the present embodiment may differ from the cell structure CS described with reference to FIGS. 5A and 5B in the shape of the shielding structure SM. In addition, a first dummy pattern 125 may be provided in the embodiment of FIGS. 20A and 20B.

The shielding structure SM may be disposed between the bit lines BL. The shielding structure SM may include the vertical portions SV and the horizontal portion SH. In detail, the vertical portions SV of the shielding structure SM may be respectively disposed between the bit lines BL. In an embodiment, a plurality of vertical portions SV may extend in the first direction D1 and may be spaced apart from each other in the second direction D2. The vertical portion SV may be spaced apart from the bit line BL, with the second insulating pattern 123 interposed therebetween. A bottom surface of the vertical portion SV may not be in contact with the word line WL. The vertical portion SV may extend to a level that is higher than a top surface of the capping layer 122 in the vertical direction D3.

The horizontal portion SH of the shielding structure SM may be disposed on the second insulating pattern 123. The horizontal portion SH may connect the vertical portions SV to each other. In detail, the shielding structures SM may include the vertical portions SV, which are respectively disposed between the bit lines BL, and the horizontal portion(s) SH, which are placed (disposed) on the second insulating pattern 123 and extend to connect the vertical portions SV to each other. In other words, the second insulating pattern 123 may be interposed between the shielding structure SM and the second capping pattern 121, the bit line BL, and the capping layer 122 and may extend to a region on the word line WL.

The shielding structure SM may be omitted between the bit lines BL, which are adjacent to the word and bit line contacts WC and BC. In detail, the shielding structure SM may be omitted from regions, which are located at opposite (e.g., both) sides of the bit line BL connected to the bit line contact BC. The shielding structure SM may be omitted from a region between the bit lines BL, which are adjacent to the word line contact WC, when viewed in a plan view. The first interlayer insulating layer 130 may extend to a space, from which the shielding structure SM is omitted. In detail, the first interlayer insulating layer 130 may extend to a space where the horizontal portion SH of the shielding structure SM is omitted, on (e.g., to cover) the second insulating pattern 123. In addition, the first interlayer insulating layer 130 may extend to a space, where the vertical portion SV of the shielding structure SM is omitted, on (e.g., to cover) top surfaces of first and second dummy patterns 125 and 126 in (e.g., filling) the space, as will be described below.

The first dummy pattern 125 may be disposed in a region between the bit lines BL where the shielding structure SM is omitted. In detail, the first dummy pattern 125 may be disposed in a space where the vertical portion SV of the shielding structure SM is omitted. Although not shown, the word line contact WC may be in (e.g., may be provided to penetrate) the second dummy pattern 126, which will be described below. Between the bit lines BL, the first and second dummy patterns 125 and 126 may have a shape that extends in the vertical direction D3. Top surfaces of the first and second dummy patterns 125 and 126 may be coplanar with the uppermost top surface the second insulating pattern 123. The first and second dummy patterns 125 and 126 may be formed of or include at least one of various insulating materials (e.g., silicon oxide, silicon nitride, silicon oxynitride, and/or low-k dielectric materials).

According to an embodiment of the inventive concept, it may be possible to separate the shielding structure SM from the word line contact WC and the bit line contact BC by a sufficiently large distance. Thus, it may be possible to reduce a process difficulty in the process of fabricating a semiconductor device.

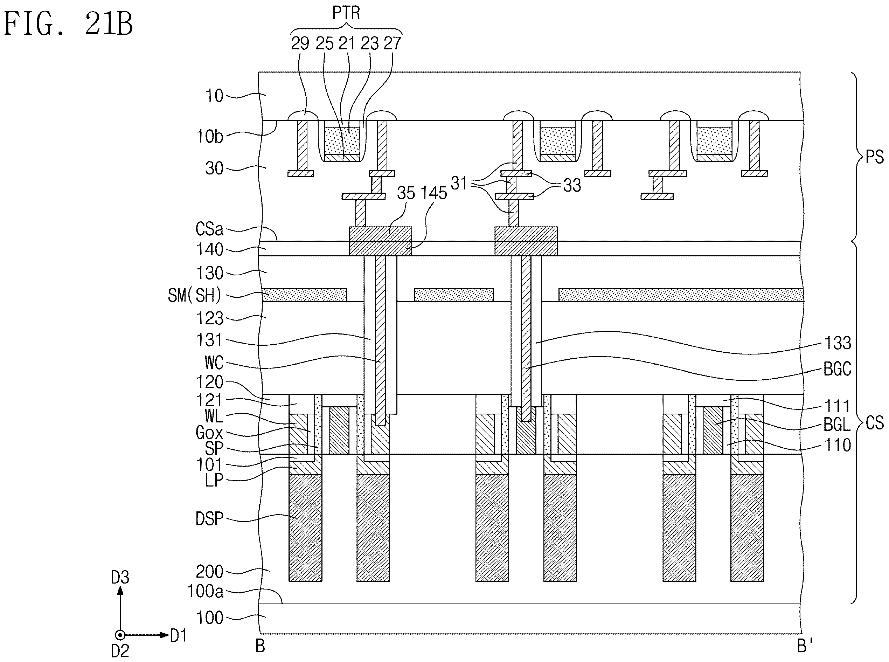

Referring to FIGS. 21A and 21B, the cell structure CS may be disposed on the substrate 100, and the peripheral circuit structure PS may be disposed on the cell structure CS. The cell structure CS may have substantially the same structural features as those in FIGS. 20A and 20B. The peripheral circuit structure PS may have substantially the same features as those in FIGS. 6A and 6B.

Top surfaces of the cell bonding pads 145 may be in direct contact with bottom surfaces of the upper bonding pads 35, respectively. The cell bonding pads 145 and the upper bonding pads 35 may form a single object without an interface therebetween. The cell bonding pads 145 and the upper bonding pads 35 are illustrated to have side surfaces that are aligned to each other, but the inventive concept is not limited to this example; for example, when viewed in a plan view, the cell bonding pads 145 and the upper bonding pads 35 may have side surfaces that are spaced apart from each other.

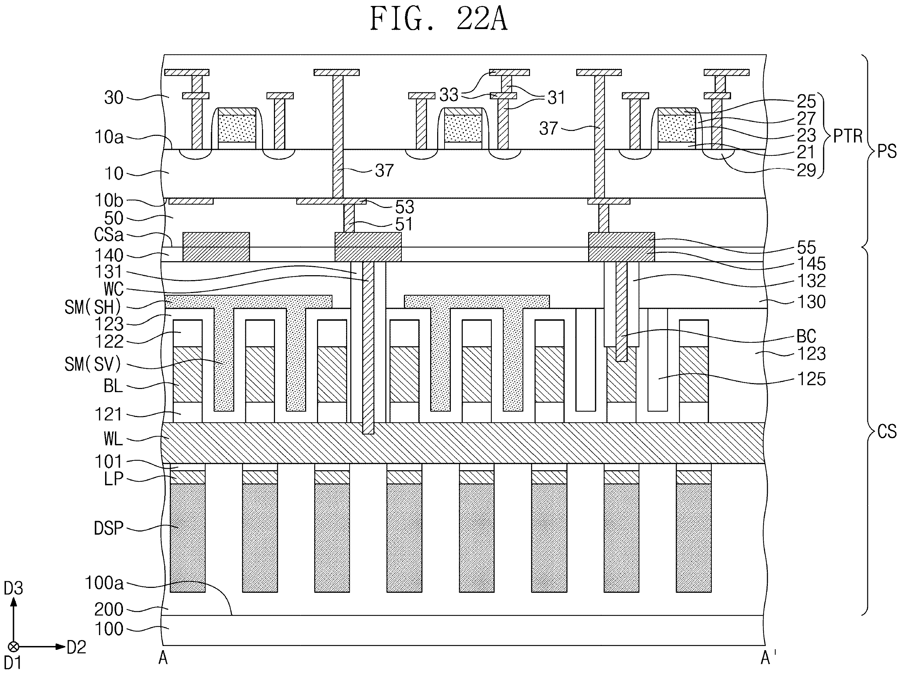

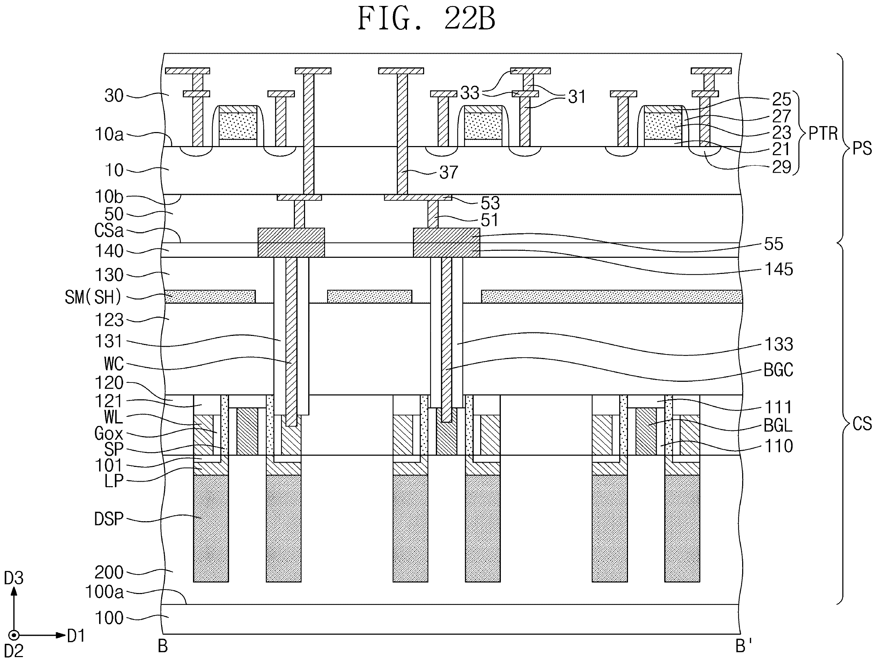

Referring to FIGS. 22A and 22B, the cell structure CS may be disposed on the substrate 100, and the peripheral circuit structure PS may be disposed on the cell structure CS. The cell structure CS may have substantially the same features as those in FIGS. 20A and 20B. The peripheral circuit structure PS may have substantially the same features as those in FIGS. 7A and 7B.

Top surfaces of the cell bonding pads 145 may be in direct contact with bottom surfaces of the lower bonding pads 55, respectively. The cell bonding pads 145 and the lower bonding pads 55 may be connected to each other, without an interface therebetween, to form a single object. The cell bonding pads 145 and the lower bonding pads 55 are illustrated to have side surfaces that are aligned to each other, but the inventive concept is not limited to this example; for example, when viewed in a plan view, the cell bonding pads 145 and the lower bonding pads 55 may have side surfaces that are spaced apart from each other.

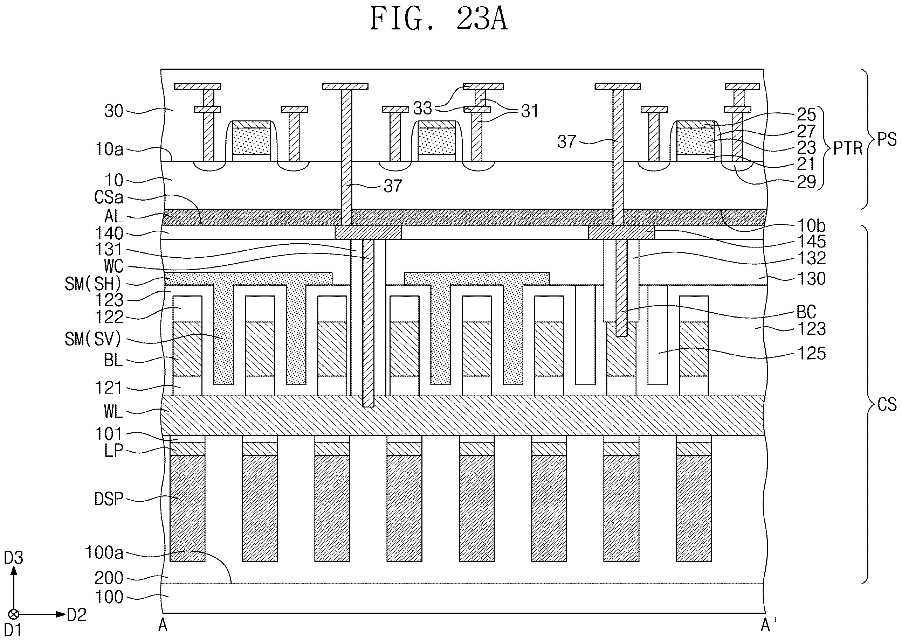

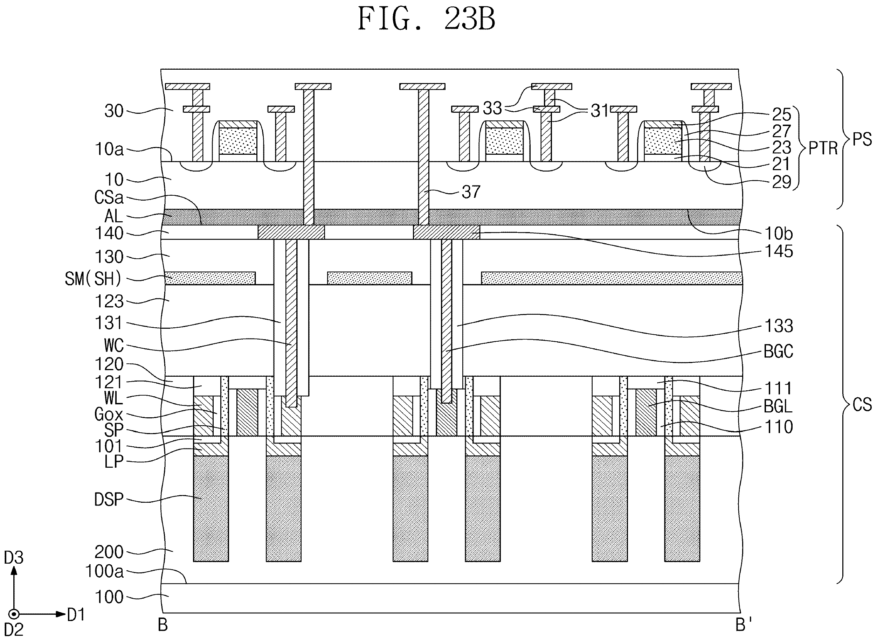

Referring to FIGS. 23A and 23B, the cell structure CS may be disposed on the substrate 100, and the peripheral circuit structure PS may be disposed on the cell structure CS. The cell structure CS may have substantially the same features as those in FIGS. 20A and 20B. The peripheral circuit structure PS may have substantially the same structural features as those in FIGS. 8A and 8B.

The interface layer AL may be disposed on the top surface CSa of the cell structure CS. The interface layer AL may be interposed between the cell structure CS and the peripheral circuit structure PS. The peripheral penetration contacts 37 may be in (e.g., may be provided to penetrate) the interface layer AL and may be electrically connected to the cell bonding pads 145 of the cell structure CS. The interface layer AL may have substantially the same features as those in FIGS. 8A and 8B.

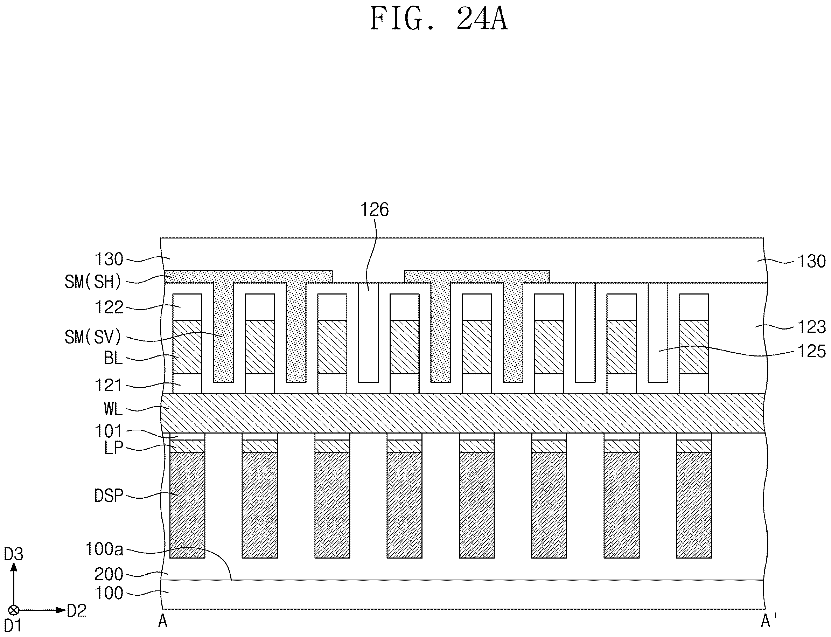

FIGS. 24A to 27B are diagrams illustrating a method of fabricating a semiconductor device, according to an embodiment of the inventive concept. For concise description, a previously described element may be identified by the same reference number without repeating an overlapping description thereof.

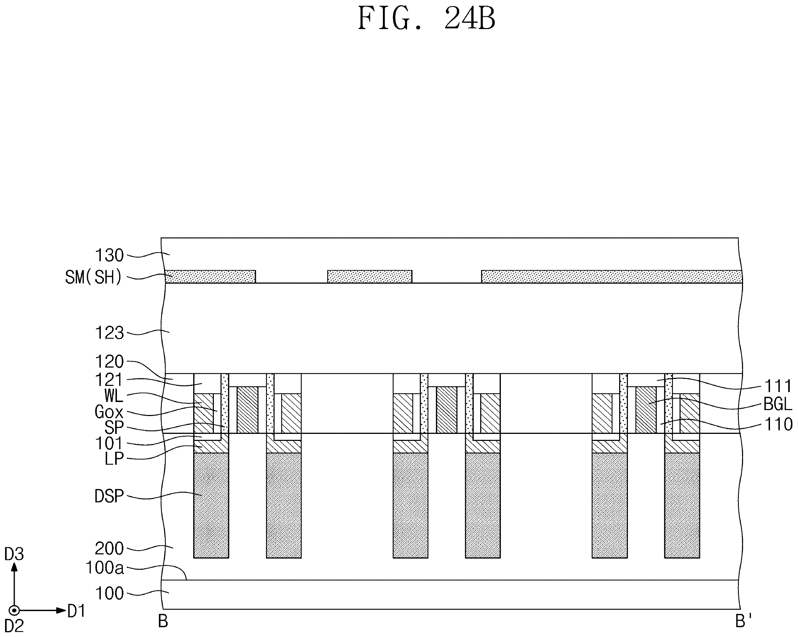

Referring to FIGS. 24A and 24B, the first insulating pattern 120, the second capping pattern 121, the back-gate capping pattern 111, the gate insulating pattern Gox, the semiconductor pattern SP, the back-gate insulating pattern 110, the word line WL, the back-gate line BGL, the first capping pattern 101, the landing pad LP, the data storage pattern DSP, and the lower insulating layer 200 may be formed on the substrate 100. The formation of the first insulating pattern 120, the second capping pattern 121, the back-gate capping pattern 111, the gate insulating pattern Gox, the semiconductor pattern SP, the back-gate insulating pattern 110, the word line WL, the back-gate line BGL, the first capping pattern 101, the landing pad LP, the data storage pattern DSP, and the lower insulating layer 200 may be achieved by substantially the same method as that described with reference to FIGS. 9A and 9B.

The bit line BL may be formed on the second capping pattern 121. The capping layer 122 may be formed on the bit line BL. The second insulating pattern 123 may be conformally formed on (e.g., to cover conformally) the second capping pattern 121, the bit line BL, and the capping layer 122. The formation of the second capping pattern 121, the bit line BL, the capping layer 122, and the second insulating pattern 123 may be achieved by substantially the same method as that described with reference to FIGS. 10A and 10B.

The first and second dummy patterns 125 and 126 may be formed between the bit lines BL, which are adjacent to the word and bit line contacts WC and BC. In detail, the first dummy pattern 125 may be formed between the bit line contact BC, which will be described below, and the bit lines BL adjacent thereto. The second dummy pattern 126 may be formed between the word line contact WC, which will be described below, and the bit lines BL adjacent thereto. In an embodiment, the formation of the first and second dummy patterns 125 and 126 may include forming a mask pattern (not shown) on the second insulating pattern 123 to open corresponding portions, forming the first and second dummy patterns 125 and 126 in the corresponding portions, and removing the mask pattern.

The shielding structure SM may be formed on the second insulating pattern 123. The shielding structure SM may include the vertical portions SV and the horizontal portion SH. The vertical portions SV of the shielding structure SM may be interposed between the second insulating patterns 123, and the horizontal portion SH of the shielding structure SM may extend to a region on a top surface of the second insulating pattern 123. However, the shielding structure SM may be omitted between the bit lines BL, which are adjacent to the word and bit line contacts WC and BC. In detail, the shielding structure SM may be omitted from regions, which are located at both sides of the bit line BL connected to the bit line contact BC. The shielding structure SM may be omitted from a region between the bit lines BL, which are adjacent to the word line contact WC, when viewed in a plan view.

In an embodiment, the formation of the shielding structure SM may include forming a shielding structure layer (not shown) and performing a planarization process on an upper portion of the shielding structure layer.

The first interlayer insulating layer 130 may be formed on the second insulating pattern 123 and the shielding structure SM. The formation of the first interlayer insulating layer 130 may be performed using a layer-forming process (e.g., chemical vapor deposition (CVD) or physical vapor deposition (PVD)).

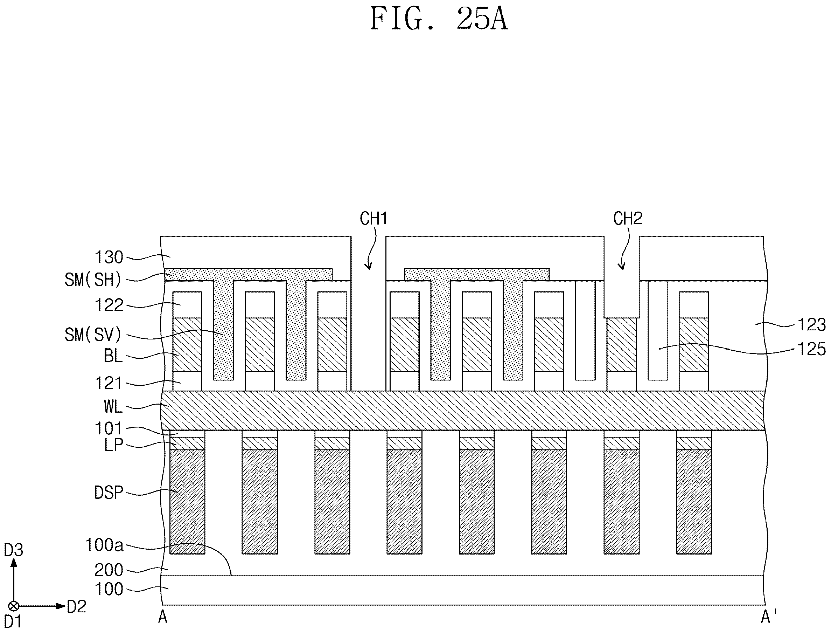

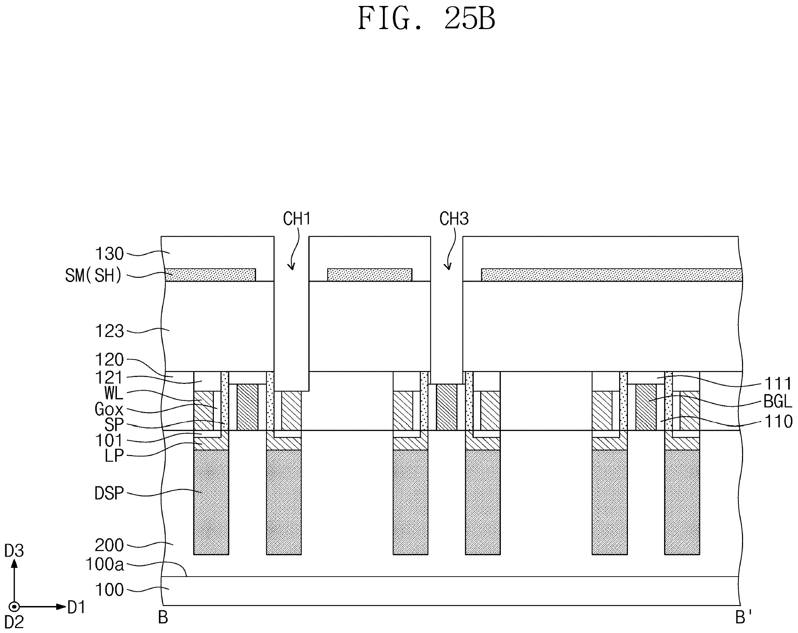

Referring to FIGS. 25A and 25B, the first and second contact holes CH1 and CH2 may be formed. In an embodiment, the formation of the first contact hole CH1 may include forming a mask pattern (not shown) on the first interlayer insulating layer 130, etching the first interlayer insulating layer 130, the second insulating pattern 123, the second dummy pattern 126, and the second capping pattern 121 using the mask pattern as an etch mask, and removing the mask pattern. The first contact hole CH1 may expose a top surface of the word line WL corresponding thereto. The formation of the second contact hole CH2 may be achieved by substantially the same method as that described with reference to the first contact hole CH1. The second contact hole CH2 may expose a top surface of the bit line BL corresponding thereto.

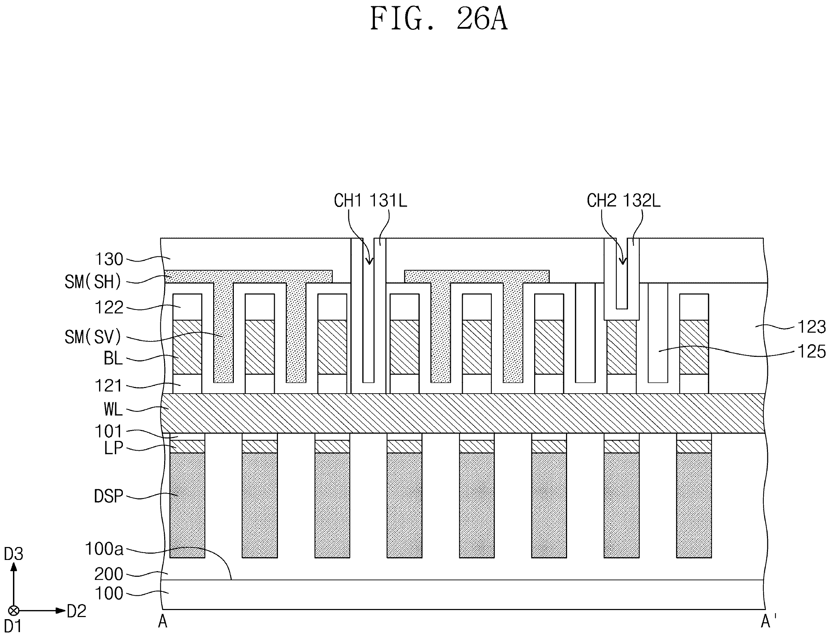

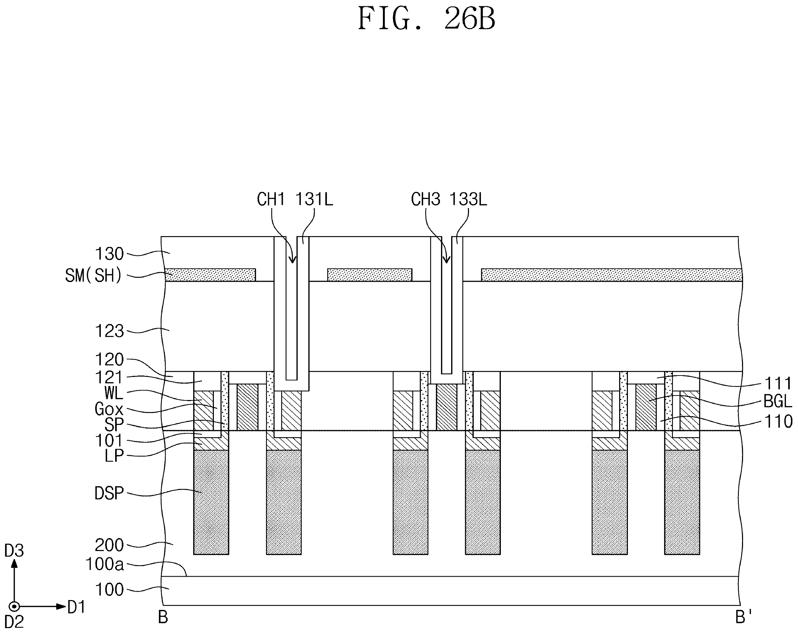

Referring to FIGS. 26A and 26B, the first spacer layer 131L may be conformally formed on (e.g., to conformally cover) a side surface of the first contact hole CH1. The formation of the first spacer layer 131L may be formed using a layer-forming process (e.g., chemical vapor deposition (CVD), physical vapor deposition (PVD), or atomic layer deposition (ALD)) having a good step-coverage property.

The second spacer layer 132L may be conformally formed on (e.g., to conformally cover) a side surface of the second contact hole CH2, and the third spacer layer 133L may be conformally formed on (e.g., to conformally cover) a side surface of the third contact hole CH3. The formation of the second and third spacer layers 132L and 133L may be achieved by substantially the same method as that described with reference to the first spacer layer 131L.

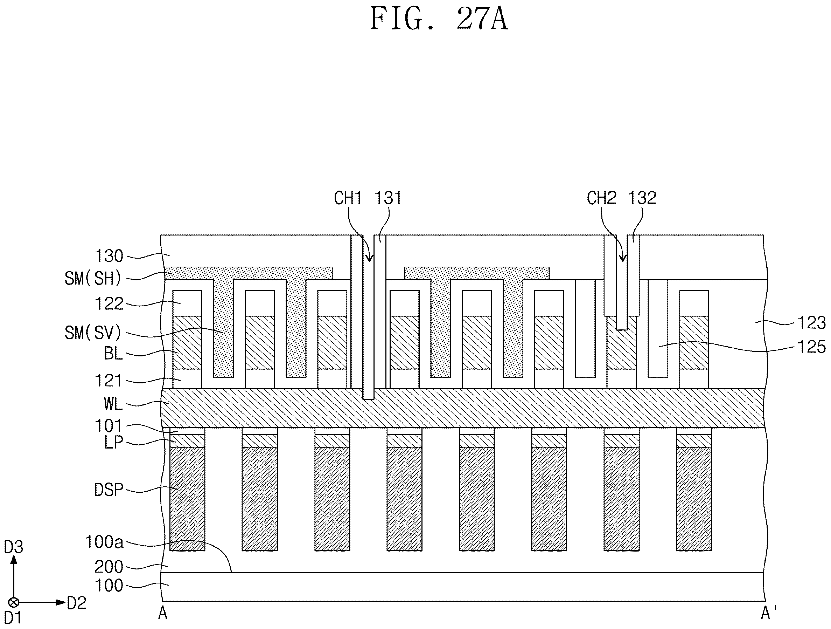

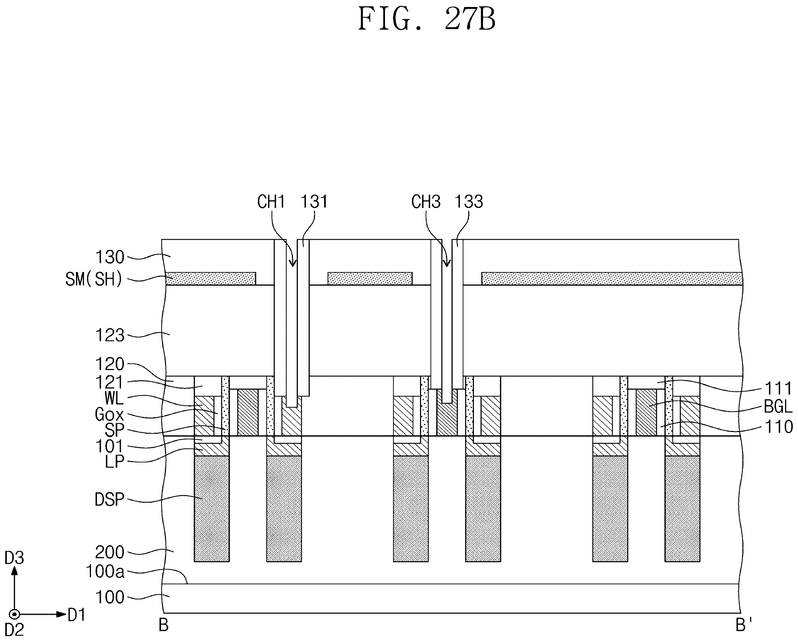

Referring to FIGS. 27A and 27B, a top surface of the word line WL may be recessed through the first contact hole CH1, and in this case, the lowermost end of the first contact hole CH1 may be placed within the word line WL. This process may include anisotropically etching the lowermost end of the first spacer layer 131L and a portion of the top surface of the word line WL through a remaining portion of the first contact hole CH1. A bottom surface of the first contact hole CH1 may be lower than the top surface of the word line WL. As a result of the etching of the lowermost end of the first spacer layer 131L, the first spacer 131 may be formed.

A top surface of the bit line BL may be recessed through the second contact hole CH2, and in this case, the lowermost end of the second contact hole CH2 may be placed within the bit line BL. This process may be performed by anisotropically etching the lowermost end of the second spacer layer 132L and a portion of the top surface of the bit line BL through a remaining portion of the second contact hole CH2. A bottom surface of the second contact hole CH2 may be lower than the top surface of the bit line BL. As a result of the etching of the lowermost end of the second spacer layer 132L, the second spacer 132 may be formed.

Referring back to FIGS. 20A and 20B, the word line contact WC may be formed in (e.g., to fill) a remaining portion of the first contact hole CH1. The bit line contact BC may be formed in (e.g., to fill) a remaining portion of the second contact hole CH2. In an embodiment, the formation of the word line contact WC and the bit line contact BC may include forming a word line contact layer (not shown) and a bit line contact layer (not shown) and performing a planarization process to expose a top surface of the first interlayer insulating layer 130.

The cell bonding pads 145 may be respectively formed on the word line contact WC and the bit line contact BC. In an embodiment, the formation of the cell bonding pads 145 may include forming a cell bonding layer (not shown) on the first interlayer insulating layer 130, forming a mask pattern (not shown) on the cell bonding layer, patterning the cell bonding layer using the mask pattern as an etch mask, and removing the mask pattern.

The second interlayer insulating layer 140 may be formed on the first interlayer insulating layer 130. The second interlayer insulating layer 140 may expose the top surfaces of the cell bonding pads 145.

In a semiconductor device according to an embodiment of the inventive concept, the word line contact WC, the bit line contact BC, and the back-gate contact BGC, which are respectively connected (e.g., electrically connected) to the word line WL, bit line BL, and back-gate line BGL, may be disposed in the cell array region CAR. Thus, there is no need to form an additional interconnection structure, which is used to allow for signal exchange between the lines and a core device, in a connection region. Thus, since the connection region and the additional interconnection structure are not needed, it may be possible to reduce the size of the semiconductor device and to fabricate the semiconductor device cost-effectively.

While example embodiments of the inventive concept have been particularly shown and described, it will be understood by one of ordinary skill in the art that variations in form and detail may be made therein without departing from the scope of the attached claims.

## Claims

1. A semiconductor device comprising:
a substrate including a cell array region;
data storage patterns on the cell array region and spaced apart from each other in a first direction and a second direction that are parallel to a top surface of the substrate and cross each other;
word lines on the data storage patterns, extending in the second direction, and spaced apart from each other in the first direction;
bit lines on the word lines to cross the word lines, extending in the first direction, and spaced apart from each other in the second direction;
an insulating pattern on the bit lines;
bit line contacts in the insulating pattern and electrically connected to the bit lines, respectively; and
word line contacts in the insulating pattern between the bit lines and electrically connected to the word lines, respectively,
wherein the bit line contacts and the word line contacts are on the cell array region.

2. The semiconductor device of claim 1, further comprising a shielding structure that is between the bit lines and extends to a region on the insulating pattern,
wherein the bit line contacts and the word line contacts are in the shielding structure.

3. The semiconductor device of claim 2, further comprising:
first spacers on side surfaces of the word line contacts; and
second spacers on side surfaces of the bit line contacts,
wherein the word line contacts are electrically isolated from the shielding structure by the first spacers, and
wherein the bit line contacts are electrically isolated from the shielding structure by the second spacers.

4. The semiconductor device of claim 2 or 3, further comprising:
back-gate lines between the word lines, extending in the second direction, and spaced apart from each other in the first direction; and
back-gate contacts in the shielding structure and the insulating pattern and electrically connected to the back-gate lines, respectively,
wherein the back-gate contacts are on the cell array region.

5. The semiconductor device of claim 4, further comprising spacers on side surfaces of the back-gate contacts,
wherein the back-gate contacts are electrically isolated from the shielding structure by the spacers.

6. The semiconductor device of any one of claims 1 to 5, further comprising:
a first interlayer insulating layer on the insulating pattern;
a second interlayer insulating layer on the first interlayer insulating layer; and
cell bonding pads on the first interlayer insulating layer,
wherein the bit line contacts and the word line contacts extend in a vertical direction that is perpendicular to the top surface of the substrate, in the first interlayer insulating layer and are electrically connected to the cell bonding pads, respectively.

7. The semiconductor device of claim 6, further comprising a peripheral circuit structure on a top surface of the second interlayer insulating layer,
wherein the peripheral circuit structure comprises peripheral circuit transistors and upper bonding pads that are electrically connected to each other, and
wherein the cell bonding pads and the upper bonding pads are in direct contact with each other.

8. The semiconductor device of claim 6 or 7, further comprising a peripheral circuit structure on a top surface of the second interlayer insulating layer,
wherein the peripheral circuit structure comprises:
peripheral circuit transistors on a peripheral substrate;
an insulating layer on a bottom surface of the peripheral substrate; and
lower bonding pads adjacent to a bottom surface of the insulating layer and electrically connected to the peripheral circuit transistors, and
wherein the cell bonding pads and the lower bonding pads are in direct contact with each other.

9. The semiconductor device of claim 6, 7 or 8, further comprising:
an interface layer on a top surface of the second interlayer insulating layer; and
a peripheral circuit structure on the interface layer,
wherein the peripheral circuit structure comprises peripheral circuit transistors and peripheral penetration contacts that are electrically connected to each other, and
wherein the peripheral penetration contacts are in the interface layer and are electrically connected to the cell bonding pads.

10. The semiconductor device of any one of claims 1 to 9, further comprising:
semiconductor patterns, each of which is at a side of a corresponding one of the word lines and extends in a vertical direction perpendicular to the top surface of the substrate; and
gate insulating patterns that are respectively between the word lines and the semiconductor patterns.

11. The semiconductor device of claim 10, further comprising landing pads on the data storage patterns, respectively,
wherein the landing pads electrically connect the data storage patterns to the semiconductor patterns.

12. The semiconductor device of any one of claims 1 to 11, further comprising:
shielding structures including vertical portions that are between the bit lines, and a horizontal portion that connects the vertical portions to each other and extends to a region on the insulating pattern; and
an interlayer insulating layer on the insulating pattern to cover the shielding structures,
wherein dummy patterns are between ones of the bit lines that are adjacent to the word line contacts and the bit line contacts, and
wherein the interlayer insulating layer extends to a region on the dummy patterns.

13. A semiconductor device as claimed in any one of claims 1 to 12 and comprising:
a cell structure on the substrate; and
a peripheral circuit structure on the cell structure,
wherein the cell structure comprises: the plurality of data storage patterns, the word lines, the bit lines, the bit line contacts, and the word line contacts; and
the cell structure further comprises, cell bonding pads, first ones of which are electrically connected to the bit line contacts and second ones of which are electrically connected to the word line contacts, and
wherein the peripheral circuit structure is electrically connected to the cell structure through the cell bonding pads.

14. The semiconductor device of claim 13,
wherein the peripheral circuit structure comprises peripheral circuit transistors and upper bonding pads that are electrically connected to each other, and
wherein the cell bonding pads and the upper bonding pads are in direct contact with each other.

15. The semiconductor device of claim 13 or 14, further comprising an interface layer between the cell structure and the peripheral circuit structure,
wherein the peripheral circuit structure comprises peripheral circuit transistors and peripheral penetration contacts that are electrically connected to each other, and
wherein the peripheral penetration contacts are in the interface layer and are electrically connected to the cell bonding pads.
